# EUROPÄISCHE PATENTSCHRIFT

(11) **EP 0 401 166 B1**
(45) Veröffentlichungstag und Bekanntmachung des Hinweises auf die Patenterteilung: **22.02.1995**
(21) Anmeldenummer: 90810378.1
(22) Anmeldetag: 23.05.1990
(51) Int. Cl.: C07F 17/00, C07F 7/28, C08F 2/50, G03F 7/027

(54) **Neue, stickstoffhaltige Titanocene und deren Verwendung**
Nitrogen-containing titanocenes and their use
Titanocènes contenant de l'azote et leur emploi

(30) Priorität: 01.06.1989 CH 2075/89
(43) Veröffentlichungstag der Anmeldung: 05.12.1990
(73) Patentinhaber: CIBA-GEIGY AG, 4002 Basel (CH)
(72) Erfinder: Steiner, Eginhard, Dr., CH-4414 Füllinsdorf (CH); Beyeler, Harry, CH-4059 Basel (CH); Hüsler, Rinaldo, Dr., CH-3184 Wünnewil (CH)

(56) Entgegenhaltungen:
- EP-A- 0 269 573
- EP-A- 0 318 893
- EP-A- 0 318 894

## Beschreibung

Die vorliegende Erfindung betrifft Titanocene mit Fluorarylresten, die mit Pyrrylalkylgruppen oder Amidoalkylgruppen substituiert sind, ein Verfahren zu ihrer Herstellung und ihre Verwendung als Photoinitiatoren für die Photopolymerisation ethylenisch ungesättigter Verbindungen.

Aus der US-A-4,590,287 ist es bekannt, dass Titanocene mit Fluorarylliganden ausgezeichnete Photoinitiatoren sind. Die Fluorarylreste dieser Titanocene können weitere Substituenten tragen, unter anderem auch Aminogruppen und Aminoalkylgruppen. In der US-A-4,857,654 sind Titanocene mit Polyoxaalkylenketten am Fluorarylliganden veröffentlicht. Die EP-A-256981 beschreibt Titanocene mit silylierten Cyclopentadienylresten. Aus der EP-A-318894 sind Titanocene mit Pyrrolsubstituenten am Fluorarylliganden bekannt, in der EP-A-318893 sind Titanocene mit stickstoffhaltigen Liganden am Fluorarylrest beschrieben, und in der US-A-4,713,401 sind Titanocene veröffentlicht, die am Arylliganden anstelle der Fluoratome CF₃-Substituenten besitzen. Titanocene mit Fluorarylresten, die durch Pyrrylalkylgruppen, Amidoalkylgruppen oder Imidoalkylgruppen substituiert sind, sind bisher nicht bekanntgeworden. Es hat sich jedoch gezeigt, dass solcherart substituierte Titanocene ebenfalls ausgezeichnete Photoinitiatoren sind.

Gegenstand der Erfindung sind Titanocene der Formel I, 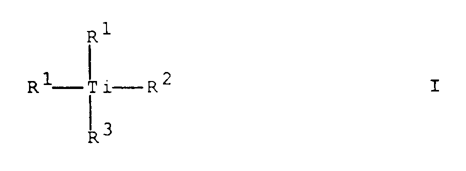
worin beide R¹ unabhängig voneinander unsubstituiertes oder ein- oder mehrfach durch C₁-C₁₈-Alkyl, C₁-C₁₈-Alkoxy, C₂-C₁₈-Alkenyl, C₅-C₈-Cycloalkyl, C₆-C₁₆-Aryl, C₇-C₁₆-Aralkyl, -Si(R⁴)₃, -Ge(R⁴)₃, Cyano oder Halogen substituiertes Cyclopentadienyl^{⊖}, Indenyl^{⊖} oder 4,5,6,7-Tetrahydroindenyl^{⊖} bedeuten und R⁴ C₁-C₁₂-Alkyl, C₅-C₁₂-Cycloalkyl, C₆-C₁₀-Aryl oder C₇-C₁₆-Aralkyl bedeutet, R² einen 6-gliedrigen carbocyclischen oder 5- oder 6-gliedrigen heterocyclischen aromatischen Ring bedeutet, der mindestens in den beiden ortho-Stellungen zur Titankohlenstoffbindung mit Fluoratomen substituiert ist und wobei der aromatische Ring weitere Substituenten enthalten kann und R³ unabhängig die Bedeutung von R² hat, wobei die Titanocene dadurch gekennzeichnet sind, dass R² und R³ durch einen Rest der Formel II, IIa oder IIb substituiert sind, 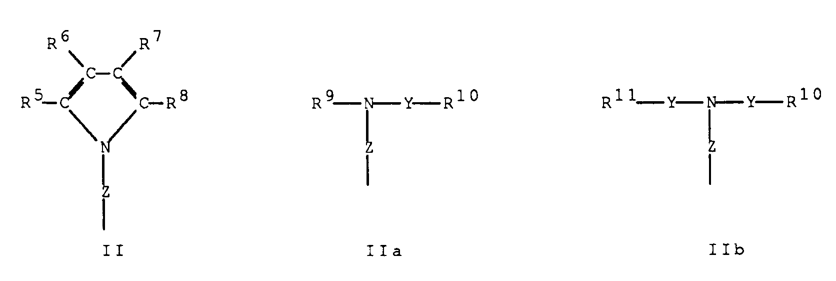
worin R⁵, R⁶, R⁷ und R⁸ unabhängig voneinander Wasserstoff, unsubstituiertes oder mit C₂-C₈-Dialkylamino, Bis[2-(C₁-C₄-alkoxy)ethyl]amino, Morpholino, Piperidino, N-Methylpiperazino, Pyrrolidino, quaternärem C₃-C₁₀-Trialkylammonium, C₁-C₁₂-Alkoxy, 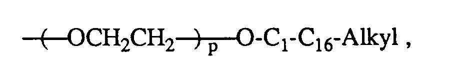
worin p eine Zahl von 1 bis 20 ist, 1,3-Dioxolan-2-yl, 4-Methyl-1,3-dioxolan-2-yl, -OCH₂CH₂O-, C₂-C₁₂-Alkoxycarbonyl, C₂-C₁₂-Alkanoyloxy, C₂-C₁₂-Alkanoyl, C₁-C₁₂-Alkylthio, Halogen, Cyano oder -Si(R⁴)₃ substituiertes lineares oder verzweigtes C₁-C₁₈-Alkyl, C₂-C₅-Alkenyl, C₇-C₉-Aralkyl, C₇-C₉-Alkaryl, C₈-C₁₀-Alkaralkyl, C₆-C₁₀-Aryl, 2-Furyl, C₅-C₈-Cycloalkyl, C₅-C₈-Cycloalkenyl, C₂-C₁₂-Alkanoyl, C₂-C₁₂-Alkoxycarbonyl, -CHO, -Si(R⁴)₃ oder -Ge(R⁴)₃ bedeuten, oder R⁵ und R⁶ und/oder R⁷ und R⁸ oder R⁶ und R⁷ jeweils zusammen -(CH₂)₃-, -(CH₂)₄-, -CH=CH-CH=CH-, -CH=CH-C(R¹²)=CH-, -CH₂OCH₂- oder -CH₂N(C₁-C₄-Alkyl)CH₂- sind, worin R¹² Hydroxyl, C₁-C₄-Alkoxy oder C₂-C₄-Alkanoyloxy bedeutet, Y eine Gruppe -CO-, -CS-, -COO-, -SO₂- oder -Si(R⁴)₂- bedeutet, R⁹ Wasserstoff, lineares oder verzweigtes C₁-C₂₀-Alkyl, C₂-C₂₀-Alkenyl, C₃-C₈-Cycloalkyl, C₄-C₂₀-Cycloalkylalkyl, C₄-C₂₀-Alkylcycloalkyl, C₅-C₂₀-Alkylcycloalkylalkyl, C₆-C₂₀-Cycloalkenylalkyl, C₆-C₁₄-Aryl, C₇-C₂₀-Aralkyl, C₇-C₂₀-Alkaryl, C₈-C₂₀-Alkaralkyl oder C₃-C₁₂-Trialkylsilyl darstellt, wobei diese Reste unsubstituiert oder durch C₁-C₁₈-Alkoxy, C₁-C₁₈-Alkylthio, C₁-C₁₈-Alkylsulfonyl, C₆-C₁₀-Arylsulfonyl, C₇-C₂₀-Alkarylsulfonyl, 2-Tetrahydrofuranyl oder Cyano substituiert sind, R¹⁰ eine der für R⁹ gegebenen Bedeutungen hat oder C₁-C₂₀-Halogenalkyl, durch -CO- unterbrochenes C₂-C₂₀-Alkyl oder durch -COOH oder -COOR⁴ substituiertes C₁-C₁₂-Alkyl ist und im Falle, dass Y -CO-, -CS- oder -SO₂- ist, auch -NR¹³R¹⁴ bedeuten kann, worin R¹³ und R¹⁴ unabhängig voneinander eine der für R⁹ gegebenen Bedeutungen haben oder R¹³ und R¹⁴ zusammen C₃-C₇-Alkylen bedeuten, das durch -O-, - S- oder -N(R¹⁵)- unterbrochen sein kann, worin R¹⁵ Wasserstoff, C₁-C₁₂-Alkyl, C₃-C₁₂-Alkenyl, C₇-C₁₂-Aralkyl oder C₂-C₂₀-Alkanoyl bedeutet, oder R⁹ und R¹⁰ zusammen lineares oder verzweigtes C₂-C₈-Alkylen oder durch Halogen, C₁-C₄-Alkoxy, Allyloxy oder - NR¹³R¹⁴ substituiertes C₂-C₈-Alkylen oder einen zweiwertigen Rest der Formel 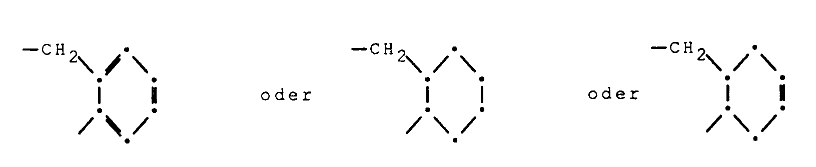
bedeuten, R¹¹ eine der für R¹⁰ gegebenen Bedeutungen hat oder R¹¹ und R¹⁰ zusammen C₁-C₈-Alkandiyl, C₂-C₈-Alkendiyl, C₆-C₁₄-Arendiyl, C₄-C₁₂-Cycloalkandiyl, C₅-C₁₂-Cycloalkendiyl, C₆-C₁₄-Cycloalkadiendiyl, C₇-C₂₀-Bicycloalkandiyl, C₇-C₂₀-Bicycloalkendiyl oder durch -O-, -S- oder -N(R¹⁵)- unterbrochenes C₂-C₄-Alkandiyl bedeuten, wobei diese Reste unsubstituiert oder durch einen oder mehrere der Substituenten Halogen, C₁-C₁₀-Alkoxy, C₁-C₂₀-Alkyl, C₃-C₂₀-Alkenyl oder C₆-C₁₄-Aryl substituiert sind, und Z unsubstituiertes oder durch -COOR⁴, - CN oder Halogen substituiertes C₁-C₂₀-Alkandiyl bedeutet.

Bei den Gruppen R¹ handelt es sich bevorzugt um gleiche Reste. Als Substituenten kommen für R¹ in Frage: lineares oder verzweigtes Alkyl oder Alkoxy mit 1 bis 18, besonders 1 bis 12 und insbesondere 1 bis 6 C-Atomen, und Alkenyl mit 2 bis 18, besonders 2 bis 12, und insbesondere 2 bis 6 C-Atomen, wie z.B. Methyl, Ethyl, Propyl, Isopropyl, n-Butyl, tert.-Butyl, Pentyl, Hexyl, Octyl, Decyl, Dodecyl, Tetradecyl, Hexadecyl, Octadecyl und entsprechende Alkenyl- und Alkoxygruppen; Cycloalkyl mit 5 bis 8 Ringkohlenstoffatomen wie z.B. Cyclopentyl, Cyclohexyl, Cycloheptyl, Methylcyclopentyl und Methylcyclohexyl; Aryl mit 6 bis 10 C Atomen und Aralkyl mit 7 bis 16 C-Atomen wie z.B. Phenyl, Napthyl, Benzyl und Phenylethyl; Cyano und Halogen, besonders F, Cl und Br; -Si(R⁴)₃ oder -Ge(R⁴)₃, worin R⁴ bevorzugt C₁-C₈-Alkyl, Cyclohexyl, Phenyl oder Benzyl ist. Beispiele für R⁴ in der Bedeutung von Alkyl sind Methyl, Ethyl, n- und i-Propyl, n-, i- und t-Butyl, Pentyl, Hexyl, Heptyl und Octyl.

Die Reste R¹ können bis zu 5, besonders aber bis zu 3 Substituenten enthalten. Bevorzugt sind beide R¹ Cyclopentadienyl^{⊖}- oder Methylcyclopentadienyl^{⊖}-Reste, insbesondere Cyclopentadienyl^{⊖}-Reste.

Bei R² in seiner Bedeutung als 6-gliedriger carbocyclischer aromatischer und Fluor-substituierter Ring kann es sich um fluorsubstituiertes Inden, Indan, Fluoren, Naphthalin und besonders Phenyl handeln. R² als heterocyclischer aromatischer und 5-gliedriger Rest enthält bevorzugt ein Heteroatom und als 6-gliedriger Ring bevorzugt 1 und 2 Heteroatome. Bevorzugt sind beide Orthostellungen mit Fluor substituiert. Beispiele sind 4,6-Difluorinden-5-yl, 5,7-Difluorindan-6-yl, 2,4-Difluorfluoren-3-yl, 1,3-Difluornaphth-2-yl, 2,6-Difluorphen-1-yl, 2,4-Difluorpyrr-3-yl, 2,4-Difluorfur-3-yl, 2,4-Difluorthien-3-yl, 2,4-Difluorpyrid-3-yl, 4,6-Difluorpyrimidin-5-yl, 3,5-Difluorpyridazin-4-yl.

In einer bevorzugten Ausführungsform ist in Formel I R² substituiertes 2,6-Difluorphen-1-yl. Insbesondere ist R² 2,6-Difluorphen-1-yl, das 1 bis 3 weitere Substituenten enthält, wovon mindestens einer ein Rest der Formel II, IIa oder IIb ist.

Bevorzugt hat R³ dieselbe Bedeutung wie R².

Eine bevorzugte Ausführungsform ist dadurch gekennzeichnet, dass R² und R³ für 2,6-Difluorphen-1-yl stehen, an das ein Rest der Formel II, IIa oder IIb gebunden ist, und das weitere 1 oder 2 gleiche oder verschiedene Substituenten enthalten kann.

Eine bevorzugte Gruppe von Titanocenen der Formel I sind solche, worin beide R¹ Cyclopentadienyl^{⊖} und R² und R³ Reste der Formel III 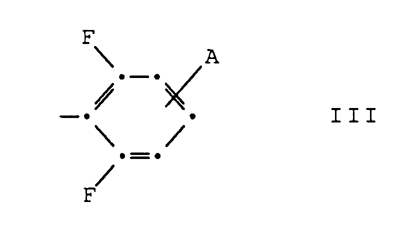
sind, worin A eine Gruppe der Formel II, IIa oder IIb bedeutet, insbesondere solche, worin A eine Gruppe der Formel II ist.

In Formel III ist die Gruppe A bevorzugt in Orthostellung zu einem F-Atom gebunden.

Substituenten an R⁵, R⁶, R⁷ und R⁸ sind z.B. C₂-C₈-, bevorzugt C₂-C₄-Di-alkylamino, z.B. Dimethyl-, Diethyl-, Di-n-propyl-, Di-n-Buryl- oder Methylethylamino; Bis[2-(C₁-C₄-alkoxy)ethyl]amino, z.B. Bis(2-methoxyethyl)amino- oder Bis(2-ethoxyethyl)-amino; Morpholino; Piperidino; N-Methylpiperazino; Pyrrolidino; quaternäres C₃-C₁₀-Trialkyl-, bevorzugt C₃-C₆-Trialkylammonium, z.B. Trimethyl-, Triethyl-, Dimethylethyl- oder Dimethylpropylammonium; C₁-C₁₂-, bevorzugt C₁-C₄-Alkoxy, z.B. Methoxy, Ethoxy, Propoxy und Butoxy; 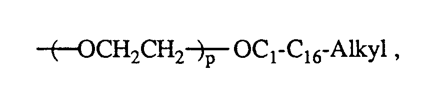
worin p bevorzugt eine Zahl von 1 bis 3 bedeutet, z.B. 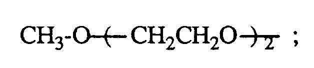
1,3-Dioxolan-2-yl; 4-Methyl-1,3-dioxolan-2-yl, -OCH₂CH₂O-, C₂-C₁₂-, bevorzugt C₂-C₆-Alkoxycarbonyl, z.B. Methoxy-, Ethoxy-, Propoxy-und Butoxycarbonyl; C₂-C₁₂-, bevorzugt C₂-C₆-Alkanoyloxy, z.B. Acetyl-, Propionyl- und Butyryloxy; C₂-C₁₂-, bevorzugt C₂-C₆-Alkanoyl, z.B. Acetyl, Propionyl und Butyryl; C₁-C₁₂-, bevorzugt C₁-C₆-Alkylthio, z.B. Methyl-, Ethyl-, Propyl- und Butylthio; Halogen, bevorzugt F, Cl und Br; Cyano; -Si(R⁴)₃, worin R⁴ bevorzugt C₁-C₆-Alkyl bedeutet, z.B. Butyl, Propyl, Ethyl und besonders Methyl.

R⁵, R⁶, R⁷ und R⁸ in der Bedeutung von Alkyl enthalten bevorzugt 1 bis 12 und besonders 1 bis 8 C-Atome. Beispiele sind Methyl, Ethyl, sowie die Isomeren von Propyl, Butyl, Pentyl, Hexyl, Heptyl, Octyl, Nonyl, Decyl, Undecyl, Dodecyl, Tridecyl, Tetradecyl, Hexadecyl und Octadecyl. In der Bedeutung von Alkenyl enthalten R⁵, R⁶, R⁷ und R⁸ bevorzugt 2 bis 4 C-Atome. Beispiele sind Vinyl, Allyl, Crotonyl, 2-Methylprop-1-en-1-yl, But-1-en-1-yl, But-2-en-2-yl, But-2-en-1-yl, But-3-en-1-yl oder -2-yl, Pent-1-en-1-yl. R⁵, R⁶, R⁷ und R⁸ in der Bedeutung von Aryl sind insbesondere Phenyl. R⁵, R⁶, R⁷ und R⁸ in der Bedeutung von Aralkyl oder Alkaryl können z.B. Benzyl, Phenylethyl, Phenylpropyl, Methylphenyl, Ethylphenyl, Propylphenyl, Dimethylphenyl und Methylethylphenyl sein. R⁵, R⁶, R⁷ und R⁸ in der Bedeutung von Alkaralkyl können z.B. Methylbenzyl, Ethylbenzyl, Propylbenzyl, (Methylphenyl)ethyl oder Dimethylbenzyl sein. R⁵, R⁶, R⁷ und R⁸ in der Bedeutung von Cycloalkyl und Cycloalkenyl stellen besonders Cyclopentyl, Cyclopentenyl, Cyclohexyl oder Cyclohexenyl dar. R⁵, R⁶, R⁷ und R⁸ in der Bedeutung von Alkanoyl enthalten bevorzugt 2 bis 8, besonders 2 bis 6 C-Atome. Beispiele sind Acetyl, Propionyl, Butanoyl, Pentanoyl, Hexanoyl, Octanoyl und Dodecanoyl. R⁵, R⁶, R⁷ und R⁸ als C₂-C₁₂-Alkoxycarbonyl sind insbesondere C₂-C₅-Alkoxycarbonyl, wie z.B. Methoxycarbonyl, Ethoxycarbonyl oder Butoxycarbonyl. R⁵, R⁶, R⁷ und R⁸ können die Gruppen -Ge(R⁴)₃ und bevorzugt -Si(R⁴)₃ bedeuten. R⁴ stellt in diesen Gruppen bevorzugt C₁-C₁₂-, besonders C₁-C₈-und insbesondere C₁-C₄-Alkyl dar. Besonders bevorzugt ist die Gruppe -Si(CH₃)₃.

In einer bevorzugten Untergruppe stellen R⁵, R⁶, R⁷ und R⁸ unabhängig voneinander Wasserstoff oder unsubstituiertes oder substituiertes C₁-C₁₂-Alkyl, C₂-C₅-Alkenyl, C₇-C₉-Phenylalkyl, C₇-C₁₀-Alkylphenyl, Phenyl, 2-Furyl, C₅- oder C₆-Cycloalkyl, C₅- oder C₆-Cycloalkenyl, C₂-C₈-Alkanoyl, C₂-C₅-Alkoxycarbonyl, -CHO oder -Si(R⁴)₃ dar, worin R⁴ C₁-C₈-Alkyl oder Phenyl ist.

In einer anderen bevorzugten Untergruppe stellen R⁵, R⁶, R⁷ und R⁸ unabhängig voneinander ein Wasserstoffatom, oder unsubstituiertes oder substituiertes C₁-C₈-Alkyl, C₂-C₄-Alkenyl, Benzyl, Phenyl, 2-Furyl, C₅- oder C₆-Cycloalkyl, C₂-C₆-Alkanoyl, C₂-C₅-Alkoxycarbonyl, -CHO oder -Si(R⁴)₃ dar, worin R⁴ C₁-C₄-Alkyl ist.

R⁹ kann substituiert sein durch C₁-C₁₈-Alkoxy, C₁-C₁₈-Alkylthio und C₁-C₁₈-Alkyl-sulfonyl, die vorzugsweise 1 bis 12, besonders 1 bis 6 und insbesondere 1 bis 4 C-Atome enthalten. Beispiele für Alkylgruppen in diesen Substituenten sind Methyl, Ethyl und die Isomeren von Propyl, Butyl, Pentyl, Hexyl, Heptyl, Octyl, Nonyl, Decyl, Undecyl, Dodecyl, Tetradecyl, Hexadecyl und Octadecyl. Weitere Substituenten für R⁹ sind Arylsulfonyl und Alkarylsulfonyl, wie z.B. Phenylsulfonyl, Tolylsulfonyl oder p-Dodecylphenylsulfonyl.

Bei R⁹ kann es sich um lineares oder verzweigtes C₁-C₂₀-, bevorzugt C₁-C₁₂- und besonders C₁-C₈-Alkyl handeln. Beispiele sind Methyl, Ethyl und die Isomeren von Propyl, Butyl, Pentyl, Hexyl, Heptyl, Octyl, Nonyl, Decyl, Undecyl, Dodecyl, Tetradecyl, Hexadecyl und Octadecyl. R⁹ kann C₃-C₈-, bevorzugt C₅ bis C₇- und besonders C₅-oder C₆-Cycloalkyl sein, z.B. Cyclopropyl, Cyclobutyl, Cyclopentyl, Cylohexyl, Cycloheptyl und Cyclooctyl. R⁹ kann C₄-C₂₀-, bevorzugt C₆-C₁₅-Cycloalkylalkyl oder - Alkylcycloalkyl sein, wobei das Cycloalkyl vorzugsweise Cyclopentyl oder Cyclohexyl ist. Beispiele sind Cyclopentyl- oder Cyclohexylmethyl, Cyclopentyl- oder Cyclohexylethyl, Cyclopentyl-oder Cyclohexylpropyl, Cyclopentyl- oder Cyclohexylbutyl, Methyl-, Dimethyl-, Ethyl-, n-Propyl-, i-Propyl-, n-Butyl-, i-Butyl-, t-Butylcyclopentyl oder - cyclohexyl. R⁹ kann C₅-C₂₀-, bevorzugt C₇-C₁₆-Alkylcycloalkylalkyl bedeuten, z.B. (Methylcyclopentyl)methyl oder -ethyl, (Methylcyclohexyl)methyl oder -ethyl.

Bei R⁹ kann es sich auch um C₆-C₁₄-, bevorzugt C₆-C₁₀-Aryl handeln, z.B. Naphthyl und besonders Phenyl. R⁹ kann auch C₇-C₂₀-, bevorzugt C₇-C₁₆-Aralkyl oder -Alkaryl sein. Das Aryl ist hierbei bevorzugt ein Phenylrest. Beispiele sind Benzyl, Phenylethyl, Phenylpropyl, Phenylbutyl, Methylphenyl, Ethylphenyl, Propylphenyl und Butylphenyl. Bei R⁹ kann es sich auch um C₈-C₂₀-, bevorzugt C₈-C₁₆-Alkaralkyl handeln, worin das Aryl bevorzugt Phenyl ist. Beispiele sind Methylbenzyl, (Methylphenyl)ethyl, (Methylphenyl)propyl, (Methylphenyl)butyl, Ethylbenzyl und Propylbenzyl.

R¹⁰ kann eine der für R⁹ gegebenen Bedeutungen haben, einschliesslich der Bevorzugungen für R⁹. Bei R¹⁰ kann es sich um C₁-C₂₀, bevorzugt C₁-C₁₂-und besonders C₁-C₆-Halogenalkyl handeln, wobei die Alkylgruppe teilweise oder ganz mit Halogen, bevorzugt Cl und/oder F substituiert sein kann. Beispiele sind Chlormethyl, Dichlormethyl, Trichlormethyl, Fluordichlormethyl, Difluorchlormethyl, Trifluormethyl, 2,2-Dichlor- oder 2,2-Difluorethyl, 1,1,1-Trichlor- oder -Trifluorethyl, Pentafluorethyl, Chlorpropyl, Fluorpropyl, Perfluorpropyl, Chlorbutyl, Fluorbutyl, Perfluorbutyl, Chlorpentyl, Perfluorpentyl und Perfluorhexyl.

Bei R⁹ und R¹⁰ kann es sich um lineares oder verzweigtes C₂-C₂₀-, bevorzugt C₂-C₁₂-und besonders C₂-C₆-Alkenyl handeln. Beispiele sind Vinyl, Crotonyl, Allyl, But-1-en-1-yl, But-1-en-4-yl, Pent-1-en-1-yl, Pent-2-en-2-yl, Hex-1-en-yl, Hex-3-en-3-yl und Hex-1-en-6-yl. R¹⁰ kann auch mit -CO- unterbrochenes C₂-C₂₀-, bevorzugt C₂-C₁₂- und besonders C₂-C₆-Alkyl sein, z.B. Acetylmethyl, Propionylmethyl, Acetylethyl und Propionylethyl.

R¹⁰ kann auch die Gruppe NR¹³R¹⁴ bedeuten, wenn Y -SO₂-, -CO- oder -CS-ist, worin R¹³ und R¹⁴ unabhängig voneinander eine der für R⁹ gegebenen Bedeutungen haben, einschliesslich bevorzugter Ausführungsformen. Bevorzugt stehen R¹³ und R¹⁴ für ein Wasserstoffatom oder C₁-C₁₂-, besonders C₁-C₆-Alkyl, z.B. Hexyl, Pentyl, Butyl, Propyl und besonders Ethyl oder Methyl.

R⁹ und R¹⁰ zusammen können bevorzugt gegebenenfalls mit Halogen substituiertes C₂-C₈-Alkylen sein, z.B. 1,2-Ethylen, 1,3-Propylen, 1,4-Butylen, 1-Dimethylethylen, 1-Methyl-1-chlormethylethylen oder 1-Diethylethylen.

Y ist bevorzugt -CO-, -COO- oder -SO₂-. R⁴ in der Gruppe -Si(R⁴)₃ bedeutet besonders Methyl.

Z als unsubstituiertes C₁-C₂₀-Alkandiyl kann linear oder verzweigt sein. Bevorzugt hat es 1-8, insbesondere 1-4 C-Atome. Beispiele hierfür sind Methylen, Di-, Tri-, Tetra-, Penta-, Hexa- oder Octamethylen, 1,2-Propylen, 1,2-Butylen oder 2,3-Dimethyl-1,4-butylen. Z kann durch -COOR⁴, -CN oder Halogen substituiert sein. Beispiele hierfür sind 2-Methoxycarbonyl-ethylen, 3-Ethoxycarbonyl-1,2-propylen, 2-Cyanoethylen, 1-Chlorethylen oder Dichlormethylen.

Bevorzugt sind Titanocene der Formel I, worin R² und R³ durch einen Rest der Formel II substituiert sind, worin R⁵, R⁶, R⁷ und R⁸ unabhängig voneinander Wasserstoff, unsubstituiertes oder durch C₂-C₈-Dialkylamino, Bis(2-methoxyethyl)amino, Morpholino, Piperidino, C₁-C₁₂-Alkoxy, 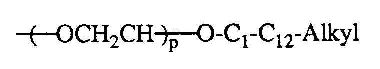
mit p = 1-3, 1,3-Dioxolan-2-yl, -OCH₂CH₂O-, C₂-C₈-Alkanoyloxy, C₁-C₈-Alkoxycarbonyl, Halogen, Cyano, C₁-C₄-Alkylthio oder -Si(CH₃)₃ substituiertes C₁-C₁₂-Alkyl, C₂-C₅-Alkenyl, C₇-C₉-Phenylalkyl, C₇-C₁₀-Alkylphenyl, Phenyl, 2-Furyl, C₅- oder C₆-Cycloalkyl, C₅- oder C₆-Cycloalkenyl, C₂-C₈-Alkanoyl, C₂-C₅-Alkoxycarbonyl, -CHO oder -Si(R⁴)₃ bedeuten, worin R⁴ C₁-C₈-Alkyl oder Phenyl ist, und Z unsubstituiertes C₁-C₈-Alkandiyl bedeutet.

Eine weitere bevorzugte Klasse von Titanocenen der Formel I, worin R² und R³ durch einen Rest der Formel II substituiert sind, sind solche, worin R⁵, R⁶, R⁷ und R⁸ unabhängig voneinander Wasserstoff, unsubstituiertes oder durch C₂-C₈-Dialkylamino, Morpholino, C₁-C₄-Alkoxy, 1,3-Dioxolan-2-yl oder Cyano substituiertes C₁-C₈-Alkyl, C₂-C₄-Alkenyl, Phenyl, 2-Furyl oder -Si(R⁴)₃ bedeuten, worin R⁴ C₁-C₄-Alkyl ist, und Z unsubstituiertes C₁-C₄-Alkandiyl bedeutet, insbesondere solche, worin R⁵, R⁶, R⁷ und R⁸ unabhängig voneinander Wasserstoff oder C₁-C₄-Alkyl sind, und solche, worin R⁶ und R⁷ Wasserstoff sind.

Eine weitere bevorzugte Klasse von Titanocenen der Formel I sind solche, worin R² und R³ durch eine Gruppe der Formel IIa substituiert sind, worin Y -CO-, -CS-, -COO- oder -SO₂- bedeutet, R⁹ Wasserstoff, unsubstituiertes oder durch C₁-C₁₂-Alkoxy oder Tetrahydrofuryl substituiertes C₁-C₁₂-Alkyl, C₂-C₅-Alkenyl, C₅-C₈-Cycloalkyl, C₆-C₁₈-Cycloalkylalkyl, C₆-C₁₈-Alkylcycloalkyl, C₇-C₁₈-Alkylcycloalkylalkyl, C₇-C₁₆-Aralkyl oder C₈-C₁₆-Alkaralkyl bedeutet, R¹⁰ eine der für R⁹ gegebenen Bedeutungen hat oder C₆-C₁₀-Aryl, C₆-C₁₀-Halogenaryl, C₇-C₁₈-Alkaryl oder C₁-C₁₂-Halogenalkyl bedeutet, oder im Falle, dass Y -CO- oder -SO₂-bedeutet, R¹⁰ auch -NR¹³R¹⁴ bedeutet, worin R¹³ und R¹⁴ unabhängig voneinander Wasserstoff, C₁-C₁₂-Alkyl, Phenyl, Benzyl oder Cyclohexyl bedeuten oder R¹³ und R¹⁴ zusammen C₄-C₅-Alkylen oder 3-Oxapentamethylen bedeuten, oder R⁹ und R¹⁰ zusammen C₂-C₈-Alkylen bedeuten, und Z unsubstituiertes C₁-C₈-Alkandiyl bedeutet.

Darunter sind solche Verbindungen bevorzugt, worin R⁹ Wasserstoff, C₁-C₁₂-Alkyl, Cyclohexyl, Cyclohexylmethyl, 2-Tetrahydrofurylmethyl, C₂-C₈-Alkoxyalkyl, Allyl oder C₇-C₉-Aralkyl ist, R¹⁰ C₁-C₁₈-Alkyl, C₁-C₄-Halogenalkyl, Cyclohexyl, C₆-C₁₀-Aryl, Halogenphenyl oder C₇-C₁₈-Alkaryl bedeutet oder R⁹ und R¹⁰ zusammen C₂-C₆-Alkylen bedeuten und Y -CO-, -COO- oder -SO₂- ist oder der Rest -Y -R¹⁰ eine Gruppe -CO-NHR¹³, -CS-NHR¹³, -CO-NR¹³R¹⁴ oder -SO₂-NR¹³R¹⁴ bedeutet, worin R¹³ C₁-C₁₂-Alkyl oder Phenyl ist, R¹⁴ C₁-C₁₂-Alkyl ist oder R¹³ und R¹⁴ zusammen C₄-C₅-Alkylen oder 3-Oxapentamethylen bedeuten, und Z unsubstituiertes C₁-C₈-Alkandiyl bedeutet, insbesondere solche Verbindungen, worin R⁹ Wasserstoff, C₁-C₈-Alkyl oder C₇-C₉-Aralkyl ist, R¹⁰ C₁-C₁₈-Alkyl, Trifluormethyl, Phenyl oder durch Halogen oder C₁-C₁₂-Alkyl substituiertes Phenyl bedeutet oder R⁹ und R¹⁰ zusammen C₂-C₆-Alkylen bedeuten, Y -CO- oder -SO₂- ist und Z unsubstituiertes C₁-C₄-Alkandiyl bedeutet.

Unter den Verbindungen der Formel I, worin R² und R³ durch eine Gruppe der Formel IIb substituiert sind, sind diejenigen bevorzugt, worin R¹⁰ und R¹¹ zusammen C₂-C₈-Alkandiyl, C₂-C₈-Alkendiyl, C₆-C₁₄-Arendiyl, Cyclohexandiyl oder C₇-C₁₂-Bicycloalkandiyl bedeuten, Y -CO- ist und Z unsubstituiertes C₁-C₄-Alkandiyl bedeutet.

Beispiele für einzelne Verbindungen der Formel I sind:
Bis(cyclopentadienyl)-bis[2,6-difluor-3-(2-(1H-pyrr-1-yl)ethyl)phenyl]-titan
Bis(cyclopentadienyl)-bis[2,6-difluor-3-(3-(1H-pyrr-1-yl)propyl)phenyl]-titan
Bis(cyclopentadienyl)-bis[2,6-difluor-3-((1H-pyrr-1-yl)methyl)phenyl]-titan
Bis(methylcyclopentadienyl)-bis[2,6-difluor-3-((1H-pyrr-1-yl)methyl)phenyl]-titan
Bis(cyclopentadienyl)-bis[2,6-difluor-3-((2,5-dimethyl-1H-pyrr-1-yl)methyl)phenyl]-titan
Bis(cyclopentadienyl)-bis[2,6-difluor-3-((2-isopropyl-5-methyl-1H-pyrr-1-yl)methyl)phenyl]-titan
Bis(cyclopentadienyl)-bis[2,6-difluor-3-((2-(2-methoxyethyl)-5-methyl-1H-pyrr-1-yl)methyl)phenyl]-titan
Bis(cyclopentadienyl)-bis[2,6-difluor-3-((3-trimethylsilyl-2,5-dimethyl-1H-pyrr-1-yl)methyl)phenyl]-titan
Bis(cyclopentadienyl)-bis[2,6-difluor-3-((2,5-dimethyl-3-(bis(2-methoxyethyl)aminomethyl)-1H-pyrr-1-yl)methyl)phenyl]-titan
Bis(cyclopentadienyl)-bis[2,6-difluor-3-((2,5-bis(morpholinomethyl)-1H-pyrr-1-yl)methyl)phenyl]-titan
Bis(cyclopentadienyl)-bis[2,6-difluor-3-((2,5-dimethyl-3-(1,3-dioxolan-2-yl)-1H-pyrr-1-yl)methyl)phenyl]-titan
Bis(cyclopentadienyl)-bis[2,6-difluor-4-((2,5-dimethyl-1H-pyrr-1-yl)methyl)phenyl]-titan
Bis(cyclopentadienyl)-bis[2,6-difluor-3-methyl-4-(2-(1H-pyrr-1-yl)ethyl)phenyl]-titan
Bis(cyclopentadienyl)-bis[2,6-difluor-3-((2,3,4,5-tetramethyl-1H-pyrr-1-yl)methyl)phenyl]-titan
Bis(cyclopentadienyl)-bis[2,3,5,6-tetrafluor-4-(3-(1H-pyrr-1-yl)propyl)phenyl]-titan
Bis(cyclopentadienyl)-bis[2,6-difluor-3-(2-(1H-pyrr-1-yl)propyl)phenyl]-titan
Bis(cyclopentadienyl)-bis[2,6-difluor-3-(1-methyl-2-(1H-pyrr-1-yl)ethyl)phenyl]-titan
Bis(cyclopentadienyl)-bis[2,6-difluor-3-(3-(2H-isoindol-2-yl)propyl)phenyl]-titan
Bis(cyclopentadienyl)-bis[2,6-difluor-3-(2-(4,5,6,7-tetrahydro-2H-isoindol-2-yl)ethyl)phenyl]-titan
Bis(cyclopentadienyl)-bis[2,6-difluor-3-(6-(9H-carbazol-9-yl)hexyl)phenyl]-titan
Bis(cyclopentadienyl)-bis[2,6-difluor-3-(3-(2,3,4,5,6,7,8,9-octahydro-1H-carbazol-9-yl)propyl)phenyl]-titan
Bis(cyclopentadienyl)-bis[2,6-difluor-3-(3-(4,5,6,7-tetrahydro-2-methyl-1H-indol-1-yl)propyl)phenyl]-titan
Bis(cyclopentadienyl)-bis[2,6-difluor-3-(2-(5-methoxy-2-methyl-1H-indol-1-yl)ethyl)phenyl]-titan
Bis(cyclopentadienyl)-bis[2,6-difluor-3-(3-(2-methyl-1H-indol-1-yl)propyl)phenyl]-titan
Bis(cyclopentadienyl)-bis[2,6-difluor-3-(4-(1,4,5,6-tetrahydro-2-methylcyclopenta[b]pyrr-1-yl)butyl)phenyl]-titan
Bis(cyclopentadienyl)-bis[2,6-difluor-3-(4-(2,3,4,5,6,7-hexahydro-1H-di-cyclopenta[b,d]pyrr-1-yl)-2,3-dimethyl)butyl)phenyl]-titan
Bis(cyclopentadienyl)-bis[2,6-difluor-3-((acetylamino)methyl)phenyl]-titan
Bis(cyclopentadienyl)-bis[2,6-difluor-3-(2-(propionylamino)ethyl)phenyl]-titan
Bis(cyclopentadienyl)-bis[2,6-difluor-3-(3-(acetylamino)propyl)phenyl]-titan
Bis(cyclopentadienyl)-bis[2,6-difluor-3-(4-(pivaloylamino)butyl)phenyl]-titan
Bis(cyclopentadienyl)-bis[2,6-difluor-3-(2-(2,2-dimethylpentanoylamino)ethyl)phenyl]-titan
Bis(cyclopentadienyl)-bis[2,6-difluor-3-(3-(benzoylamino)propyl)phenyl]titan
Bis(cyclopentadienyl)-bis[2,6-difluor-3-((2,2-dimethylpentanoylamino)methyl)phenyl]-titan
Bis(cyclopentadienyl)-bis[2,6-difluor-3-(2-(2,2-dimethyl-3-chlorpropanoylamino)ethyl)phenyl]-titan
Bis(cyclopentadienyl)-bis[2,6-difluor-3-((2,2-dimethyl-3-ethoxypropanoylamino)methyl)phenyl]-titan
Bis(cyclopentadienyl)-bis[2,6-difluor-3-(2-(lauroylamino)ethyl)phenyl]-titan
Bis(cyclopentadienyl)-bis[2,6-difluor-3-((N-hexyl-(2,2-dimethylpentanoyl)amino)methyl)phenyl]-titan
Bis(cyclopentadienyl)-bis[2,6-difluor-3((N-ethyl-propionylamino)methyl)phenyl]-titan
Bis(cyclopentadienyl)-bis[2,6-difluor-3-(2-(N-methyl-acetylamino)ethyl)phenyl]-titan
Bis(cyclopentadienyl)-bis[2,6-difluor-3-(3-(N-(2-methoxyethyl)-isobutyrylamino)propyl)phenyl]-titan
Bis(cyclopentadienyl)-bis[2,6-difluor-3-(2-(N-cyclohexyl-(3-phenylpropanoyl)amino)ethyl)phenyl]-titan
Bis(cyclopentadienyl)-bis[2,6-difluor-3-(2-(N-(oxolan-2-ylmethyl)-(4-toluyl)amino)ethyl)phenyl]-titan
Bis(cyclopentadienyl)-bis[2,6-difluor-3-(3-(N-allyl-acetylamino)propyl)phenyl]-titan
Bis(cyclopentadienyl)-bis[2,6-difluor-3-(2-(N-benzyl-decanoylamino)propyl)phenyl]-titan
Bis(cyclopentadienyl)-bis[2,6-difluor-3-((N-butyl-(4-tolylsulfonyl)amino)methyl)phenyl]-titan
Bis(cyclopentadienyl)-bis[2,6-difluor-3-(2-(N-allyl-methylsulfonylamino)ethyl)phenyl]-titan
Bis(cyclopentadienyl)-bis[2,6-difluor-3-(3-(N-isobutyl-phenylsulfonylamino)propyl)phenyl]-titan
Bis(cyclopentadienyl)-bis[2,6-difluor-3-((methylsulfonylamino)methyl)phenyl]-titan
Bis(cyclopentadienyl)-bis[2,6-difluor-3-(3-(ethylsulfonylamino)propyl)phenyl]-titan
Bis(cyclopentadienyl)-bis[2,6-difluor-3-(2-(butylsulfonylamino)ethyl)phenyl]-titan
Bis(cyclopentadienyl)-bis[2,6-difluor-3-(3-(4-tolylsulfonylamino)propyl)phenyl]-titan
Bis(cyclopentadienyl)-bis[2,6-difluor-3-(3-(methylsulfonylamino)-2-methyl-propyl)phenyl]-titan
Bis(cyclopentadienyl)-bis[2,6-difluor-3-((hexadecylsulfonylamino)methyl)phenyl]-titan
Bis(cyclopentadienyl)-bis[2,6-difluor-3-(3-(2-naphtylsulfonylamino)propyl)phenyl]-titan
Bis(cyclopentadienyl)-bis[2,6-difluor-3-(2-(3,3-diallyl-2-pyrrolidon-1-yl)ethyl)phenyl]-titan
Bis(cyclopentadienyl)-bis[2,6-difluor-3-((3,3-dimethyl-2-azetidinon-1-yl)methyl)phenyl]-titan
Bis(cyclopentadienyl)-bis[2,6-difluor-3-(3-(N-(2,3-dihydro-1,2-benzisothiazol-3-on-1,1-dioxid-2-yl))propyl)phenyl]-titan
Bis(cyclopentadienyl)-bis[2,6-difluor-4-(2-(N-phthalimido)ethyl)phenyl]-titan
Bis(cyclopentadienyl)-bis[2,6-difluor-3-(2-(phthalimido)ethyl)phenyl]-titan
Bis(cyclopentadienyl)-bis[2,6-difluor-3-(3-(pyrrolidin-2,5-dion-1-yl)propyl)phenyl]-titan
Bis(cyclopentadienyl)-bis[2,6-difluor-3-(2-(3,4-dimethyl-3-pyrrolin-2,5-dion-1-yl)propyl)phenyl]-titan
Bis(cyclopentadienyl)-bis[2,6-difluor-3-(2-(3,3-dimethyl-2-pyrrolidinon-1-yl)ethyl)phenyl]-titan
Bis(cyclopentadienyl)-bis[2,6-difluor-3-(2-(3,3-diallyl-2-piperidinon-1-yl)ethyl)phenyl]-titan
Bis(cyclopentadienyl)-bis[2,6-difluor-3-(3-(6,6-diphenyl-2-piperidinon-1-yl)propyl)phenyl]-titan
Bis(pentamethylcyclopentadienyl)-bis[2,6-difluor-3-(4-(3-allyloxymethyl-3-methyl-2-azetidinon-1-yl)butyl)phenyl]-titan
Bis(cyclopentadienyl)-bis[2,6-difluor-3-[6-(3-ethoxymethyl-3-methyl-2-azetidinon-1-yl)hexyl)phenyl]-titan
Bis(methylcyclopentadienyl)-bis[2,6-difluor-4-(3-(3,3-diallyl-2-pynolidinon-1-yl)propyl)phenyl]-titan
Bis(cyclopentadienyl)-bis[2,6-difluor-3-(2-(isobutoxycarbonylamino)ethyl)phenyl]-titan
Bis(cyclopentadienyl)-bis[2,6-difluor-3-((ethoxycarbonylamino)methyl)phenyl]-titan
Bis(cyclopentadienyl)-bis[2,6-difluor-3-(3-((2-chlorethoxy)carbonylamino) propyl)phenyl]-titan
Bis(cyclopentadienyl)-bis[2,6-difluor-3-(4-(phenoxycarbonylamino)butyl)phenyl]-titan
Bis(cyclopentadienyl)-bis[2,6-difluor-3-(2-(phenylthiocarbonylamino)ethyl)phenyl]-titan
Bis(cyclopentadienyl)-bis[2,6-difluor-3-(2-(3-phenylthioureido)ethyl)phenyl]-titan
Bis(cyclopentadienyl)-bis[2,6-difluor-3-(3-(3-butylthioureido)propyl)phenyl]-titan
Bis(cyclopentadienyl)-bis[2,6-difluor-3-((3-phenylureido)methyl)phenyl]-titan
Bis(cyclopentadienyl)-bis[2,6-difluor-3-(2-(3-butylureido)ethyl)phenyl]-titan
Bis(cyclopentadienyl)-bis[2,6-difluor-3-(2-(3,3-dimethylureido)ethyl)phenyl]-titan
Bis(cyclopentadienyl)-bis[2,6-difluor-3-(2-(N,N-diacetylamino)ethyl)phenyl]-titan
Bis(cyclopentadienyl)-bis[2,6-difluor-3-((N-phenylsulfonyl-N-acetylamino)methyl)phenyl]-titan
Bis(cyclopentadienyl)-bis[2,6-difluor-3-(((trifluormethylsulfonyl)amino)methyl)phenyl]-titan
Bis(cyclopentadienyl)-bis[2,6-difluor-3-(2-(trifluoracetylamino)ethyl)phenyl]-titan
Bis(cyclopentadienyl)-bis[2,6-difluor-3-((N-methyl-(4-dodecylphenyl)sulfonylamino)methyl)phenyl]-titan
Bis(cyclopentadienyl)-bis[2,6-difluor-3-(4-(N-ethyl(4-bromphenyl)sulfonylamino)butyl)phenyl]-titan
Bis(methylcyclopentadienyl)-bis[2,6-difluor-3-(2-(hexadecylsulfonylamino)ethyl)phenyl]-titan
Bis(trimethylsilylcyclopentadienyl)-bis[2,6-difluor-3-(2-(N-(2-ethylhexyl)-(4-tolylsulfonylamino)ethyl)phenyl]-titan
Bis(cyclopentadienyl)-bis[2,6-difluor-3-((N-(2-methoxyethyl)-(trimethylsilyl)amino)methyl)phenyl]-titan
Bis(cyclopentadienyl)-bis[2,6-difluor-3-((3-(N-butyl)-(1,1,2-trimethylpropyl)dimethylsilylamino)propyl)phenyl]-titan
Bis(cyclopentadienyl)-bis[2,6-difluor-3-((2,2,5,5-tetramethyl-1,2,5-azadisilolidin-1-yl)methyl)phenyl]-titan
Bis(cyclopentadienyl)-bis[2,6-difluor-3-(2-(cyclohexylcarbonylamino)ethyl)phenyl]-titan
Bis(cyclopentadienyl)-bis[2,3,5,6-tetrafluor-4-((butyrylamino)methyl)phenyl]-titan
Bis(cyclopentadienyl)-bis[2,6-difluor-3-(2-(3,4-xyloylamino)ethyl)phenyl]-titan
Bis(cyclopentadienyl)-bis[2,6-difluor-3-(2-(2-chlormethyl-2-methy-3-chlorpropanoylamino)propyl)phenyl]-titan
Bis(cyclopentadienyl)-bis[2,6-difluor-3-((2,2-dimethyl-3-allyloxypropanoylamino)-methyl)phenyl]-titan
Bis(cyclopentadienyl)-bis[2,6-difluor-3-(2-(2,2-dimethyl-3-ethoxypropanoylamino)ethyl)phenyl]-titan
Bis(cyclopentadienyl)-bis[2,6-difluor-3-(2-(2,2-dimethyl-3-chlorpropanoylamino)butyl)phenyl]-titan
Bis(cyclopentadienyl)-bis[2,6-difluor-3-(2-(N-cyclohexylmethyl-pivaloylamino)ethyl)phenyl]-titan
Bis(cyclopentadienyl)-bis[2,6-difluor-3-((N-(oxolan-2-ylmethyl)-(2,2-di-methylpentanoyl)amino)methyl)phenyl]-titan
Bis(cyclopentadienyl)-bis[2,6-difluor-3-(2-(N-(1,3-dimethylbutyl)-(2,2-dimethylbutanoyl)amino)ethyl)phenyl]-titan
Bis(cyclopentadienyl)-bis[2,6-difluor-3-(3-(N-cyclohexyl-(2,2-dimethylpropanoyl)amino)propyl)phenyl]-titan
Bis(cyclopentadienyl)-bis[2,6-difluor-3-(3-(N-isopropyl-(2,2-dimethylpropanoyl)amino)decyl)phenyl]-titan
Bis(cyclopentadienyl)-bis[2,6-difluor-3-(2-(N-isopropyl-(4-toluyl)amino)ethyl)phenyl]-titan
Bis(cyclopentadienyl)-bis[2,6-difluor-3-(2-carbethoxy-3-(N-allyl-acetylamino)propyl)phenyl]-titan
Bis(cyclopentadienyl)-bis[2,6-difluor-3-((N-(3-oxaheptyl)-(2,2-dimethylpentanoyl)amino)methyl)phenyl]-titan
Bis(cyclopentadienyl)-bis[2,6-difluor-3-((N-ethyl-(5-carbethoxypentanoyl)amino)methyl)phenyl]-titan
Bis(cyclopentadienyl)-bis[2,6-difluor-3-(2-((4-carboxybutanoyl)amino)ethyl)phenyl]-titan
Bis(cyclopentadienyl)-bis[2,6-difluor-4-methyl-3-(3-(N-(3,7-dimethyl-7-methoxy-octyl)benzoylamino)propyl)phenyl]-titan
Bis(cyclopentadienyl)-bis[2,6-difluor-3-(3-(3,4-tetramethylen-2-pyrrolidinon-1-yl)propyl)phenyl]-titan
Bis(cyclopentadienyl)-bis[2,6-difluor-3-(3-(benzo[c]-2-pyrrolidinon-1-yl)propyl)phenyl]-titan

Die Herstellung der Titanocene der Formel I kann nach bekannten oder analogen Verfahren erfolgen, indem man 1 Mol einer Verbindung der Formel IV, 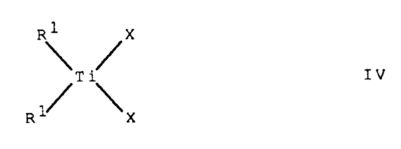
worin R¹ die vorhin angegebene Bedeutung hat und X für Halogen, besonders Chlor, steht, mit einem Mol LiR² und mit einem Mol LiR³ oder mit 2 Mol LiR² umsetzt, wobei R² und R³ die zuvor angegebenen Bedeutungen haben, und danach die Verbindungen der Formel I in an sich bekannter Weise isoliert.

Die bekannten Verfahren sind z.B. in J. Organometal. Chem., 2 (1964) 206-212, J. Organometal. Chem., 4 (1965) 445-446 und in der EP-A-122 223 beschrieben.

Die Ausgangsverbindungen der Formel IV, in denen X besonders für Chlor steht, sind bekannt oder können nach analogen Verfahren durch die Umsetzung von TiCl₄ mit den Natriumverbindungen NaR¹ erhalten werden. Die Lithiumverbindungen LiR² und LiR³ sind neu. Sie können z.B. nach an sich bekannten Verfahren durch Umsetzung von Lithiumbutyl mit HR² bzw. HR³ hergestellt werden. Dies wird in den folgenden Beispielen näher beschrieben.

Die Herstellung der Verbindungen HR² und HR³ kann nach an sich bekannten Verfahren in analoger Weise erfolgen. Vorzugsweise stellt man zunächst die entsprechenden Aminoalkylfluorarene her, beispielsweise durch Reduktion der entsprechenden Nitrile. Die primären Amine können mit 1,4-Dicarbonylverbindungen oder mit 2,5-Dimethoxytetrahydrofuran in Pyrrolderivate, die einen Rest der Formel II enthalten, umgewandelt werden.

Die Einführung des Restes R⁹ kann durch reduktive Aminierung der entsprechenden Aldehyde oder Ketone geschehen. Die Einführung der Reste R¹⁰Y- und R¹¹Y-kann mittels der Halogenverbindungen R¹⁰-Y-X und R¹¹-Y-X oder mittels der Säureanhydride (R¹⁰Y)₂O erfolgen.

Als Beispiel für die Herstellung einer Verbindung HR² sei hier das Schema der Herstellung von 1-(2,4-Difluorphenylmethyl)pyrrol aufgezeigt: 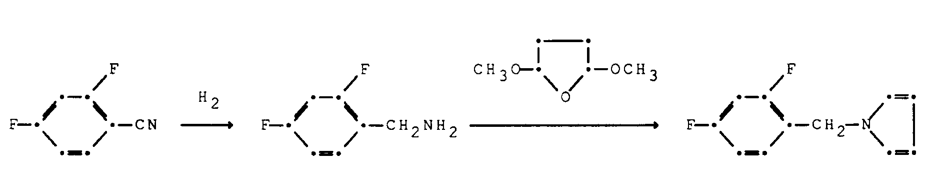
Die Herstellung der Metallocene der Formel I aus den Verbindungen HR² und HR³ erfolgt im allgemeinen in Gegenwart inerter Lösungsmittel wie z.B. Kohlenwasserstoffen oder Ethern und unter Schutzgasatmosphäre. In einer Ausführungsform des Verfahrens wird zunächst LiR² bzw. LiR³ durch Umsetzung von HR² bzw. HR³ in einem Ether als Lösungsmittel, z.B. Tetrahydrofuran, mit Lithiumbutyl bei Temperaturen um - 78°C hergestellt. Zu der gekühlten Reaktionsmischung gibt man dann das entsprechende Titanocendihalogenid, entfernt die Kühlung und lässt auf Raumtemperatur erwärmen. Die Reaktionsmischung wird dann, gegebenenfalls nach Zugabe von Lösungsmitteln, filtriert und aus der Lösung durch Ausfallen oder Verdampfen des Lösungsmittels das erfindungsgemässe Titanocen isoliert.

In einer anderen Ausführungsform wird ein Gemisch von HR² und Titanocendichlorid in Tetrahydrofuran bei -25 bis - 10°C mit einer Lösung eines Lithiumamides, wie z.B. mit Lithium-diisopropylamid, umgesetzt. Nach Abtrennen des gebildeten LiCl wird das Titanocen wie üblich isoliert.

Die Titanocene sind im allgemeinen kristalline, meist orange-gefärbte Verbindungen, die sich durch eine hohe thermische Stabilität auszeichnen und sich erst bei hohen Temperaturen zersetzen. Auch unter Lufteinwirkung sowie unter Einwirkung von Wasser wird keine Zersetzung beobachtet. Die Verbindungen können in härtbaren Zusammensetzungen auch in höheren Mengen gelöst werden, und bieten daher wertvolle anwendungstechnische Eigenschaften. Die Verbindungen sind auch in Lösungsmitteln gut löslich, und können in Form von Lösungen in härtbare Zuammensetzungen eingearbeitet werden, wonach das Lösungsmittel gegebenenfalls entfernt wird.

Die Verbindungen sind dunkellagerstabil und können ohne Schutzgas gehandhabt werden. Sie eignen sich alleine hervorragend als sehr wirksame Photoinitiatoren für die lichtinduzierte Polymerisation ethylenisch ungesättigter Verbindungen. Sie zeichnen sich hierbei durch eine sehr hohe Lichtempfindlichkeit und Wirksamkeit über einen grossen Wellenlängenbereich von ca. 200 nm (UV-Licht) bis etwa 600 nm aus. Ferner vermögen die Titanocene auch wirksam die Polymerisation unter dem Einfluss von Wärme zu initiieren, wobei ein Erwärmen auf 170°C bis 240°C zweckmässig ist. Selbstverständlich kann auch Lichteinwirkung und Erwärmung zur Polymerisation benutzt werden, wobei eine Erwärmung nach der Belichtung tiefere Temperaturen, z.B. 80-150°C, zur Polymerisation erlaubt.

Ein weiterer Gegenstand vorliegender Erfindung ist eine durch Strahlung polymerisierbare Zusammensetzung, enthaltend (a) mindestens eine nichtflüchtige, monomere, oligomere oder polymere Verbindung mit mindestens einer polymerisierbaren ethylenisch ungesättigten Doppelbindung und (b) mindestens ein Titanocen der Formel I als Photoinitiator.

Die Zusammensetzungen können weitere von (b) verschiedene Photoinitiatoren (c), z.B. solche vom Typ der Benzophenone, Benzoinalkylether, Benzilketale, 4-Aroyl-1,3-dioxolane, Dialkoxyacetophenone, α-Hydroxy- oder α-Aminoacetophenone, α-Hydroxycycloalkylphenylketone oder Mischungen davon enthalten. Der Vorteil besteht darin, dass man geringere Mengen der erfindungsgemässen Titanocene verwenden kann und trotzdem gleiche oder verbesserte Lichtempfindlichkeiten erzielen kann.

Die Zusatzmenge der erfindungsgemässen Titanocene richtet sich im wesentlichen nach wirtschaftlichen Gesichtspunkten, deren Löslichkeiten und nach der gewünschten Empfindlichkeit. Im allgemeinen werden 0,01 bis 20, vorzugsweise 0,05-10 und besonders 0,1 bis 5 Gew.% verwendet, bezogen auf die Komponente (a).

Als Komponente (a) kommen solche ethylenisch ungesättigten monomeren, oligomeren und polymeren Verbindungen in Frage, die durch Photopolymerisation zu höhermolekularen Produkten reagieren und hierbei ihre Löslichkeit verändern.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z.B. ungesättigte Polyester, Polyamide und Polyurethane und Copolymere davon, Polybutadien und Butadien-Copolymere, Polyisopren und Isopren-Copolymere, Polymere und Copolymere mit (Meth)Acrylgruppen in Seitenketten, sowie Mischungen von zwei oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere oder Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3 oder 1,4-Butandiol, Pentandiol, Hexandiol, Octandiol, Dodecandiol, Diethylenglykol, Triethylenglykol, Polyethylenglykole mit Molekulargewichten von bevorzugt 200 bis 1500,1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind: Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldimethacrylat, 1,3-Butandioldiacrylat, 1,3-Butandioldimethacrylat, 1,4-Butandioldiitaconat, Sorbittriacrylat, Sorbittetraacrylat, Pentaerythrit-modifiziert-triacrylat, Sorbittetramethacrylat, Sorbitpentaacrylat, Sorbithexaacrylat, Oligoesteracrylate und -methacrylate, Glyzerindi-und -triacrylat, 1,4-Cyclohexandioldiacrylat, Bisacrylate und Bismethacrylate von Polyethylenglykol mit Molekulargewicht von 200-1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di(β-aminopropoxy)ethan. Weitere geeignete Polyamine sind Polymere und Copolymere mit Aminogruppen in der Seitenkette und Oligoamide mit Aminoendgruppen.

Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N[(β-Hydroxyethoxy)ethyl]acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)Acrylate, Acrylnitril, Styrol oder Vinylchlorid. Polymere mit (Meth)Acrylatgruppen in der Seitenkette sind ebenfalls bekannt. Es kann sich z.B. um Umsetzungsprodukte von Epoxidharzen auf Novolakbasis mit (Meth)Acrylsäure handeln, um Homo- oder Copolymere des Polyvinylalkohols oder deren Hydroxyalkylderivaten, die mit (Meth)Acrylsäure verestert sind, oder um Homo- und Copolymere von (Meth)Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt Die Menge des Bindemittels kann z.B. 5-95, vorzugsweise 10-90 und besonders 50-90 Gew.% betragen, bezogen auf die gesamte Zusammensetzung. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000 bis 1 000 000. Beispiele sind: Homo- und copolymere Acrylate und Methacrylate, z.B. Copolymere aus Methylmethacrylat/Ethylacrylat/Methacrylsäure, Poly(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polyamide wie Polycaprolactam und Poly(hexamethylenadipamid), Polyester wie Poly(ethylenglykolterephthalat) und Poly(hexamethylenglykolsuccinat).

Die erfindungsgemässen Zusammensetzungen eignen sich als Beschichtungsmittel für Substrate aller Art, z.B. Holz, Papier, Keramik, Kunststoffe, wie Polyester-und Celluloseacetatfilme, und Metalle, wie Kupfer und Aluminium, bei denen durch Photopolymerisation eine Schutzschicht oder eine photographische Abbildung aufgebracht werden soll. Ein weiterer Gegenstand vorliegender Erfindung sind die beschichteten Substrate und ein Verfahren zum Aufbringen photographischer Abbildungen auf den Substraten. Die beschichteten Substrate können auch als Aufzeichnungsmaterial für Hologramme (Volumen-Phasen-Diagramm) verwendet werden, wobei vorteilhaft ist, dass für diesen Zweck keine Nassentwicklung notwendig ist.

Die Beschichtung der Substrate kann erfolgen, indem man eine flüssige Zusammensetzung, eine Lösung oder Suspension auf das Substrat aufbringt. Flüssige Zusammensetzungen ohne Lösungsmittel sind bevorzugt. Hierbei kann es zweckmässig sein, die erfindungsgemässen Titanocene in Form eines flüssigen Photoinitiatorengemisches, enthaltend andere Photoinitiatoren, z.B. ein Benzilketal, ein 4-Aroyl-1,3-dioxolan, ein Dialkoxyacetophenon, ein α-Hydroxy-oder α-Aminoacetophenon, ein α-Hydroxycycloalkylphenylketon oder Mischungen hiervon einzusetzen. Besonders vorteilhaft sind flüssige Mischungen aus flüssigen bis festen Photoinitiatoren und flüssigen Titanocenen oder flüssigen Photoinitiatoren und sirupösen bis festen Titanocenen. Diese Gemische bieten anwendungstechnische Vorteile und zeichnen sich durch eine hohe Dunkellagerstabilität aus.

Beispiele für Benzilketale sind solche der Formel 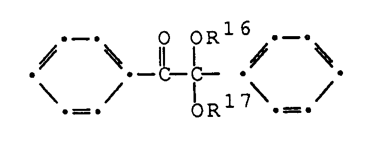
- R¹⁶=R¹⁷: =-CH₃
-CH₂CH₃
-(CH₂)₂CH₃
-(CH₂)₃CH₃
-CH₂CH₂CH(CH₃)₂ 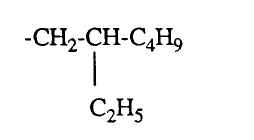 -(CH₂)₉CH₃
-C₁₀H₂₁-iso
-C₁₂H₂₅-n
-C₉H₁₉ bis -C₁₁H₂₃-Gemisch
-C₁₂-H₂₅-bis-C₁₅H₃₁-Gemisch
-CH₂CH=CH₂
-CH(CH₃)CH=CH₂
-CH₂CH₂OC₃H₇-iso
-CH₂CH₂OC₄H₉
-CH₂CH₂OCH₂CH=CH₂
-CH(CH₃)-CH₂OC₄H₉
-CH₂COOCH₃
-CH₂COOC₄H₉
-CH(CH₃)COOCH₃
-CH₂CH₂COOC₂H₅
-CH(CH₃)CH₂COOCH₃
-CH₂CH₂CH(CH₃)OCH₃ 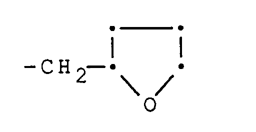 -(CH₂CH₂O)₂CH₃
-(CH₂CH₂O)₂C₂H₅
-(CH₂CH₂O)₂C₄H₉
-(CH₂CH₂O)₃CH₃
-(CH₂CH₂O)₃C₂H₅
-(CH₂CH₂O)₃C₁₂H₂₅
-(CH₂CH₂O)₅C₁₀H₂₁
-(CH₂CH₂O)₈C₉H₁₉-bis-C₁₁H₂₃ (Gemisch) 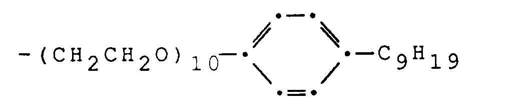 -CH₂CH₂N(C₂H₅)₂ 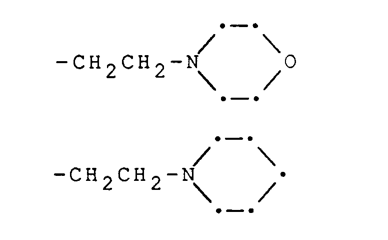 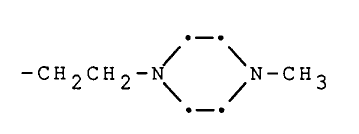
- R¹⁷=: -CH₃, R¹⁶=-C₆H₁₃
- R¹⁷ =: -CH₃, R¹⁶ = -C₁₀H₂₁
- R¹⁷ =: -CH₃, R¹⁶ = (̵CH₂CH₂O)₃-C₁₂H₂₅ bis-C₁₅H₃₁ (Gemisch)
- R¹⁷ =: -CH₃, R¹⁶ = (̵CH₂CH₂O)₅-C₉H₁₉ bis -C₁₁H₂₃ (Gemisch)
- R¹⁷ =: -CH₃, R¹⁶=

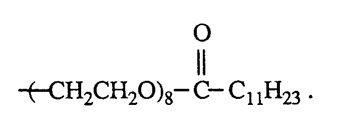

Beispiele für 4-Aroyl-1,3-dioxolane sind:
4-Benzoyl-2,2,4-trimethyl-1,3-dioxolan
4-Benzoyl-4-methyl-2,2-tetramethylen-1,3-dioxolan
4-Benzoyl-4-methyl-2,2-pentamethylen-1,3-dioxolan
cis-trans 4-Benzoyl-2,4-dimethyl-2-methoxymethyl-1,3-dioxolan
cis-trans 4-Benzoyl-4-methyl-2-phenyl-1,3-dioxolan
4-(4-Methoxybenzoyl)-2,2,4-trimethyl-1,3-dioxolan
4-(4-Methoxybenzoyl)-4-methyl-2,2-pentamethylen-1,3-dioxolan
4-(4-Methylbenzoyl)-2,2,4-trimethyl-1,3-dioxolan
cis-trans 4-Benzoyl-2-methyl-4-phenyl-1,3-dioxolan
4-Benzoyl-2,2,4,5,5-pentamethyl-1,3-dioxolan
cis-trans 4-Benzoyl-2,2,4,5-tetramethyl-1,3-dioxolan
cis-trans 4-Benzoyl-4-methyl-2-pentyl-1,3-dioxolan
cis-trans 4-Benzoyl-2-benzyl-2,4-dimethyl-1,3-dioxolan
cis-trans 4-Benzoyl-2-(2-furyl)-4-methyl-1,3-dioxolan
cis-trans 4-Benzoyl-5-phenyl-2,2,4-trimethyl-1,3-dioxolan
4-(4-Methoxybenzoyl)-2,2,4,5,5-pentamethyl-1,3-dioxolan.

Beispiele für Dialkoxyacetophenone sind:
α,α-Dimethoxyacetophenon
α,α-Diethoxyacetophenon
α,α-Di-isopropoxyacetophenon
α,α-Di-(2-methoxyethoxy)acetophenon
α-Butoxy-α-ethoxyacetophenon
α,α-Dibutoxy-4-chloracetophenon
α,α-Diethoxy-4-fluoracetophenon
α,α-Dimethoxy-4-methylacetophenon
α,α-Diethoxy-4-methylacetophenon
α,α-Dimethoxypropiophenon
α,α-Diethoxypropiophenon
α,α-Diethoxybutyrophenon
α,α-Dimethoxyisovalerophenon
α,α-Diethoxy-α-cyclohexylacetophenon
α,α-Dipropoxy-4-chlorpropiophenon.

Beispiele für α-Hydroxy- und α-Aminoacetophenone sind:
2-Hydroxy-2-methyl-1-phenylpropanon-1
2-Hydroxy-2-ethyl-1-phenylhexanon-1
1-(4-Dodecylphenyl)-2-hydroxy-2-methylpropanon-1
1-(2,4-Dimethylphenyl)-2-hydroxy-2-methylpropanon-1
2-Hydroxy-1-(4-methoxyphenyl)-2-methylpropanon-1
2-Hydroxy-2-methyl-1-phenylbutanon-1
2-Dimethylamino-2-methyl-1-phenylpropanon-1
2-Dibutylamino-2-methyl-1-phenylpropanon-1
1-(4-Fluorphenyl)-2-methyl-2-morpholinopentanon-1
2-Methyl-1-(4-methylthiophenyl)-2-morpholinopropanon-1
2-Dimethylamino-1-(4-methoxyphenyl)-2-methylpropanon-1
2-Diethylamino-1-(4-diethylaminophenyl)-2-methylpropanon-1
2-Benzyl-2-dimethylamino-1-(4-methoxyphenyl)-butanon-1
2-Benzyl-2-dimethylamino-1-(4-tolyl)-butanon-1
2-Benzyl-2-dimethylamino-1-phenylbutanon-1
2-Benzyl-2-dimethylamino-1-(4-chlorphenyl)-butanon-1
2-Benzyl-2-dimethylamino-1-(3,4-dimethoxyphenyl)-butanon-1
2-Benzyl-2-dimethylamino-1-(3,4-dimethoxyphenyl)-pentanon-1
2-Benzyl-2-dimethylamino-1-[4-(2-hydroxyethylthio)phenyl]-butanon-1
2-Dimethylamino-2-(4-methylphenylmethyl)-1-(3,4-dimethoxyphenyl)-butanon-1
2-Dimethylamino-2-(4-methylphenylmethyl)-1-(4-morpholinophenyl)-butanon-1
2-Benzyl-2-dimethylamino-1-(4-morpholinophenyl)-butanon-1
2-Benzyl-2-dimethylamino-1-(4-morpholinophenyl)-pentanon-1
2-Benzyl-2-dimethylamino-1-(4-dimethylaminophenyl)-butanon-1
2-Allyl-2-dimethylamino-1-(4-morpholinophenyl)-pent-4-en-1-on
2-Allyl-1-(4-morpholinophenyl)-2-morpholino-pent-4-en-1-on.

Beispiele für α-Hydroxycycloalkylphenylketone sind:
α-Hydroxycyclohexylphenylketon
α-Hydroxycyclopentylphenylketon

Das Photoinitiatorengemisch (b) + (c) kann in Mengen von 0,5-20, vorzugsweise 1 bis 10 Gew.-%, zugegeben werden, bezogen auf die Komponente (a).

Das Gewichtsverhältnis der Komponenten (b):(c) kann von 1:1 bis 30:1, bevorzugt von 5:1 bis 15:1 betragen.

Die Wahl des Lösungsmittels und die Konzentration richtet sich hauptsächlich nach der An der Zusammensetzung und nach dem Beschichtungsverfahren. Die Zusammensetzung wird mittels bekannter Beschichtungsverfahren auf ein Substrat gleichförmig aufgebracht, z.B. durch Tauchen, Rakelbeschichtung, Vorhanggiessverfahren, Elektrophorese, Aufpinseln, Spritzen oder Reverseroll-Beschichtung. Die Auftragsmenge (Schichtdicke) und Art des Substrates (Schichtträger) sind abhängig vom gewünschten Applikationsgebiet. Als Schichtträger für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckter Schaltungen kupferkaschierte Laminate. Die Schichtdicken für photographische Materialien und Offsetdruckformen betragen im allgemeinen ca. 0,5 bis ca. 10 »m; für gedruckte Schaltungen im allgemeinen 1 bis ca. 100 »m. Bei Mitverwendung von Lösungsmitteln werden diese nach dem Beschichten entfernt.

Die erfindungsgemässen Titanocene können auch als Photoinitiatoren in lichthärtbaren Zusammensetzungen für Dentalapplikationen verwendet werden. Sie liefern mit kurzen Bestrahlungszeiten Materialien von hoher Festigkeit und einem geringen Grad an restlichen ungesättigten Komponenten. Durch Belichten von dentalen Zusammensetzungen, basierend auf olefinischen ungesättigten Harzen, anorganischen Füllern und Titanocen-Photoinitiatoren, lassen sich mit kommerziellen Lichtquellen für Dentalapplikationen innerhalb von wenigen Sekunden Härtungstiefen von einigen Millimetern erreichen. Beispiele für Zusammensetzungen von Dentalmassen, die mit erfindungsgemässen Verbindungen gehärtet werden können, sowie nähere Details über Bindemittel, Füllstoffe, weitere Zusätze und Applikationsverfahren sind z.B. der EP-A-334338 und der DE-A-3801511 zu entnehmen.

Photohärtbare Zusammensetzungen, wie sie für die verschiedenen Zwecke verwendet werden, enthalten meist ausser den photopolymerisierbaren Verbindungen und den Photoinitiatoren eine Reihe sonstiger Zusätze. So ist es vielfach üblich, thermische Inhibitoren zuzusetzen, die vor allem während der Herstellung der Zusammensetzungen durch Mischen der Komponenten vor einer vorzeitigen Polymerisation schützen sollen. Hierzu werden beispielsweise Hydrochinon, Hydrochinonderivate, p-Methoxyphenol, β-Naphthole oder sterisch gehinderte Phenole wie z.B. 2,6-Di(tert-butyl)-p-kresol verwendet Weiter können geringe Mengen von UV-Absorbern zugesetzt werden, wie z.B. solche vom Benztriazol-, Benzophenon- oder Oxalanilid-Typ. Ebenso lassen sich Lichtschutzmittel vom Typus sterisch gehinderter Amine (HALS) zusetzen.

Zur Erhöhung der Dunkellagerstabilität können Kupferverbindungen, wie Kupfernaphthenat, -stearat, oder -octoat, Phosphorverbindungen, wie Triphenylphosphin, Tributylphosphin, Triethylphosphit, Triphenylphosphit oder Tribenzylphosphit, quaternäre Ammoniumverbindungen, wie Tetramethylammoniumchlorid oder Trimethyl-benzylammoniumchlorid oder Hydroxylaminderivate, wie z.B. N-Diethylhydroxylamin, zugesetzt werden.

Um die inhibierende Wirkung des Luftsauerstoffs auszuschliessen setzt man photohärtbaren Gemischen häufig Paraffin oder ähnliche wachsartige Stoffe zu. Diese schwimmen bei Beginn der Polymerisation wegen mangelnder Löslichkeit im Polymeren aus und bilden eine transparente Oberflächenschicht, die den Zutritt von Luft verhindert.

Weitere übliche Zusätze sind Photosensibilisatoren, welche in bestimmten Wellenlängen absorbieren und die absorbierte Energie an den Initiatoren weitergeben oder selbst als zusätzlicher Initiator fungieren. Beispiele hierfür sind vor allem Thioxanthon-, Anthracen-, Anthrachinon- und Cumarinderivate.

Weitere übliche Zusätze sind Beschleuniger vom Amin-Typ, die vor allem in pigmentierten Zubereitungen von Bedeutung sind, da sie als Kettenüberträger wirken. Beispiele hierfür sind N-Methyldiethanolamin, Triethylamin, p-Dimethylaminobenzoesäureethylester oder Michler's Keton. Die Wirkung der Amine kann verstärkt werden durch den Zusatz von aromatischen Ketonen vom Benzophenontyp. Weitere übliche Beschleuniger sind 1,3,4-Thiadiazolderivate, wie z.B. 2-Mercapto-5-methylthio-1,3,4-thiadiazol.

Weitere übliche Zusätze sind z.B. Füllstoffe, Pigmente, Farbstoffe, Haft-, Netz- und Verlaufmittel.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Druckfarben von Bedeutung.

Gut geeignet sind die erfindungsgemässen photohärtbaren Zusammensetzungen auch zur Herstellung von Druckplatten, insbesondere Flexodruckplatten. Hierbei werden z.B. Gemische von löslichen linearen Polyamiden oder von Styrol-Butadien-Kautschuk mit photopolymerisierbaren Monomeren, beispielsweise Acrylamiden oder Acrylaten, und einem Photoinitiator verwendet. Filme und Platten aus diesen Systemen werden über das Negativ (oder Positiv) der Druckvorlage belichtet und die ungehärteten Anteile anschliessend mit einem Lösungsmittel eluiert.

Ein weiteres Einsatzgebiet der Photohärtung ist die Metallbeschichtung, beispielsweise bei der Lackierung von Blechen für Tuben, Dosen oder Flaschenverschlüsse, sowie die Photohärtung von Kunststoffbeschichtungen, beispielsweise von Fussboden-oder Wandbelägen auf PVC-Basis.

Beispiele für die Photohärtung von Papierbeschichtungen sind die farblose Lackierung von Etiketten, Schallplatten-Hüllen oder Buchumschlägen.

Wichtig ist auch die Verwendung der photohärtbaren Zusammensetzungen für Abbildungsverfahren und zur optischen Herstellung von Informationsträgern. Hierbei wird die auf dem Träger aufgebrachte Schicht (nass oder trocken) durch eine Photomaske mit kurzwelligem Licht bestrahlt und die unbelichteten Stellen der Schicht durch Behandlung mit einem Lösungsmittel (= Entwickler) entfernt. Die belichteten Stellen sind vernetztpolymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte Schaltungen und Photoresists herstellen.

Zur Belichtung eignen sich Lichtquellen mit hohem Anteil an kurzwelligem Licht. Hierfür stehen heute entsprechende technische Vorrichtungen und verschiedene Lampenarten zur Verfügung. Beispiele sind Kohlelichtbogenlampen, Xenonlichtbogenlampen, Quecksilberdampflampen, Metall-Halogenlampen, Fluoreszenzlampen, Argonlampen oder photographische Flutlichtlampen. Neuerdings werden auch Laserlichtquellen verwendet. Diese haben den Vorteil, dass keine Photomasken notwendig sind; der gesteuerte Laserstrahl schreibt direkt auf die photohärtbare Schicht.

Die folgenden Beispiele beschreiben die Herstellung der Zwischenprodukte, der Titanocene und deren Anwendung als Photoinitiatoren.

### A) Herstellung der Zwischenprodukte

### Beispiel 1: 2,4-Difluorbenzylamin

13,9 g (0,10 Mol) 2,4-Difluorbenzonitril werden in 100 ml Ethanol gelöst und in einem Druckreaktor nach Zugabe von 1,4 g Raney-Nickel in Ethanol und nach Aufpressen von 17 g (1,0 Mol) Ammoniakgas bei 75-80°C mit Wasserstoffgas hydriert. Die Wasserstoffaufnahme ist nach ca. 2 Stunden beendet. Das Reaktionsgemisch wird nach dem Erkalten, Entspannen und Filtrieren am Vacuumrotationsverdampfer von Lösungsmittel befreit. Das erhaltene Oel wird bei 70-75°C im Vacuum (19 mbar) fraktioniert destilliert. Man erhält 9,5 g (66 % der Theorie) einer farblosen Flüssigkeit.

| Analyse: C₇H₇F₂N (143,14) | | | | |
|---|---|---|---|---|
| | C | H | F | N |
| ber.: | 58,74 | 4,93 | 26,55 | 9,79 % |
| gef.: | 58,8 | 5,0 | 26,1 | 9,8 % |

### Beispiel 2: 1-[(2,4-Difluorphenyl)methyl]-1H-pyrrol

8,6 g (0,060 Mol) 2,4-Difluorbenzylamin werden in einem Autoklaven mit 8 g (0,060 Mol) 2,5-Dimethoxytetrahydrofuran während zwei Stunden auf 250°C erhitzt. Das Reaktionsgemisch wird nach dem Erkalten durch Vacuumdestillation gereinigt. Man erhält 9,2 g (79 % der Theorie) eines farblosen Oels, das bei 110-114°C bei 16 mbar siedet.

| Analyse: C₁₁H₉F₂N (193,20) | | | | |
|---|---|---|---|---|
| | C | H | F | N |
| ber.: | 68,39 | 4,70 | 19.67 | 7,25 % |
| gef.: | 69,1 | 4,9 | 19,2 | 6,9 % |

### Beispiel 3: 1-[(2,4-Difluorphenyl)methyl]-2,5-dimethyl-1H-pyrrol

42,9 g (0,30 Mol) 2,4-Difluorbenzylamin werden in 300 ml Ethanol gelöst. Diese Lösung wird mit 5 Tropfen konzentrierter Salzsäure (36 %) versetzt. Dann wird 36,0 g (0,315 Mol) Acetonylaceton zugetropft und zum Rückfluss erwärmt. Nach 4,5 Stunden Rückfluss bei ca. 80°C ist die Reaktion beendet (GC-Kontrolle). Die braune Lösung wird auf - 30°C gekühlt und die ausgefallenen Kristalle werden abfiltriert und getrocknet. Man erhält 56,2 g (85 % der Theorie) weisse Kristalle, die bei 41-42°C schmelzen.

| Analyse: C₁₃H₁₃F₂N (221,25) | | | | |
|---|---|---|---|---|
| | C | H | F | N |
| ber.: | 70,57 | 5,92 | 17,17 | 6,33 % |
| gef.: | 70,3 | 6,1 | 17,0 | 6,2 % |

### Beispiel 4: 1-[(2,4-Difluorphenyl)methyl]-2,2,5,5-tetramethyl-1,2,5-azadisilolidin

In 200 ml Dichlormethan werden 107,6 g (0,50 Mol) 1,2-Bis-(chlordimethylsilyl)-ethan vorgelegt. Dazu lässt man in 2,5 Stunden eine Lösung von 71,6 g (0,50 Mol) 2,4-Difluorbenzylamin und 101,2 g (1,0 Mol) Triethylamin in 300 ml Dichlormethan bei Raumtemperatur zutropfen. Es entsteht eine weisse Suspension. Das Ende der Reaktion wird gaschromatographisch überprüft. Dann werden 400 ml 10%ige Natriumdihydrogenphosphatlösung zugegeben, um das ausgefallene Triethylammoniumchlorid zu lösen. Die organische Phase wird abgetrennt, mit Magnesiumsulfat getrocknet, filtriert und am Vacuumrotationsverdampfer eingeengt. Das trübe Oel wird in 300 ml Petrolether aufgenommen, geklärt und erneut eingeengt. Man erhält 124,7 g einer farblosen Flüssigkeit, die durch eine fraktionierte Destillation bei 125-127°C und 15 mbar gereinigt wird. Es werden 85,3 g (60 % der Theorie) an reinem Produkt erhalten.

| Analyse: C₁₃H₂₁F₂NSi₂ (285,48) | | | | | |
|---|---|---|---|---|---|
| | C | H | N | F | Si |
| ber.: | 54,69 | 7,41 | 4,91 | 13,31 | 19,67 % |
| gef.: | 54,5 | 7,5 | 4,9 | 13,1 | 19,8 % |

### Beispiel 5: 3-(2,4-Difluorphenyl)-2-propensäure-ethylester

In 240 ml Eisessig werden 51,6 g (0,40 Mol) 2,4-Difluoranilin gelöst. Dazu werden unter Kühlung langsam 45 ml (0,80 Mol) konzentrierte Schwefelsäure zugegeben. Die weisse Suspension wird mit einer Lösung von 28,0g (0,406 Mol) Natriumnitrit in 70 ml Wasser bei 12-15°C diazotiert. Zur entstandenen gelben Lösung werden bei 45°C 1,2 g (0,0044 Mol) Palladium-bis(1,5-diphenyl-1,4-pentadien-3-on) (Lit.: M.F. Rettig et al., Inorg. Synth. 17 (1977), 134) zugesetzt. Darauf werden 40,5 g (0,405 Mol) Ethylacrylat zugetropft. Die Reaktion ist schwach exotherm und die Temperatur steigt langsam auf ca. 60°C. Man lässt über Nacht bei fallender Temperatur ausrühren und giesst dann das Reaktionsgemisch auf ca. 600 ml Eiswasser. Die wachsartige Fällung wird mit 500 ml Diethylether extrahiert. Die Etherphase wird abgetrennt, mehrmals mit Eiswasser gewaschen und dann mit Natriumsulfat getrocknet. Der Ether wird am Vacuumrotationsverdampfer abdestilliert. Man erhält 51,2 g (60 % der Theorie) eines wachsartigen kristallinen Produktes, das nach dem Umkristallisieren aus Petrolether bei 40-40,5°C schmilzt.

| Analyse: C₁₁H₁₀F₂O₂ (212,20) | | | |
|---|---|---|---|
| | C | H | F |
| ber.: | 62,26 | 4,75 | 17,91 % |
| gef.: | 62,2 | 4,8 | 17,6 % |

### Beispiel 6 3-(2,4-Difluorphenyl)propansäure-ethylester

In 400 ml Ethanol werden 42,4 g (0,20 Mol) 3-(2,4-Difluorphenyl)-2-propensäureethylester gelöst und nach Zugabe von 4 g Raney-Nickel im Ethanol bei 20-25°C mit Wasserstoffgas hydriert. Nach der Aufnahme der theoretischen Menge an Wasserstoff wird die Lösung filtriert und am Vacuumrotationsverdampfer eingeengt. Man erhält 41,4 g eines hellbraunen Oels, das bei 120°C im Vacuum (20 mbar) fraktioniert destilliert wird. Man gewinnt 33 g (77 % der Theorie) eines farblosen Oels.

| Analyse: C₁₁H₁₂F₂O₂ (214,21) | | | |
|---|---|---|---|
| | C | H | F |
| ber.: | 61,68 | 5,65 | 17,74 % |
| gef.: | 61,7 | 5,8 | 17,7 % |

### Beispiel 7: 3-(2,4-Difluorphenyl)-propansäure

In 250 ml Wasser werden 33 g (0,154 Mol) 3-(2,4-Difluorphenyl)-propansäure-ethylester suspendiert. Dann werden 60 ml 10N-Natronlauge und 30 ml 40%ige Tetrabutylammoniumhydroxid-Lösung zugegeben. Es wird kräftig gerührt und erwärmt. Bei ca. 50°C ist alles gelöst. Man erwärmt weiter auf 80°C und kühlt dann auf 5°C ab. Durch Zutropfen von 80 ml konzentrierter Salzsäure fallen weisse Kristalle aus, die abfiltriert und mit Eiswasser gewaschen werden. Nach dem Trocknen im Vacuum erhält man 28,1 g (98 % der Theorie) weisse Kristalle vom Schmelzpunkt 107-108°C, der sich auch nach einer Umkristallisation aus 50%igem Ethanol nicht verändert.

| Analyse: C₉H₈F₂O₂ (186,16) | | | |
|---|---|---|---|
| | C | H | F |
| ber.: | 58,07 | 4,33 | 20,41 % |
| gef.: | 57,8 | 4,4 | 20,4 % |

### Beispiel 8: 3-(2,4-Difluorphenyl)-propanamid

In einem Sulfierkolben werden 27,9 g (0,15 Mol) 3-(2,4-Difluorphenyl)-propansäure mit 50 ml (0,69 Mol) Thionylchlorid und 0,5 ml Dimethylformamid gemischt und eine Stunde bei Raumtemperatur, eine Stunde bei 50°C und eine halbe Stunde am Rückfluss gerührt. Im Vacuum wird dann das überschüssige Thionylchlorid abdestilliert. Der orangebraune ölige Rückstand wird in Toluol gelöst und dann auf - 15°C abgekühlt. Bei dieser Temperatur werden in ca. einer Stunde 7,0 g (0,41 Mol) Ammoniakgas eingeleitet. Darauf lässt man die Temperatur auf Raumtemperatur steigen. Dann wird das teilweise kristalline Reaktionsgemisch auf 500 ml Eiswasser gegossen. Der Rückstand wird filtriert, mit wenig Toluol gewaschen und im Vacuum getrocknet. Man erhält 21,7 g (78 % der Theorie) weisse Kristalle vom Schmelzpunkt 107-108°C. Das Produkt schmilzt nach einer Umkristallisation aus Wasser bei 109-110°C.

| Analyse: C₉H₉F₂NO (185,17) | | | | |
|---|---|---|---|---|
| | C | H | F | N |
| ber.: | 58,38 | 4,90 | 20,52 | 7,56 % |
| gef.: | 58,0 | 4,9 | 20,5 | 7,7 % |

### Beispiel 9: 2-(2,4-Difluorphenyl)-ethylamin

37,2 g (0,20 Mol) 3-(2,4-Difluorphenyl)-propanamid werden bei Raumtemperatur in die Lösung von 38,8 g (0,24 Mol) Brom in 750 ml 2N Natronlauge langsam eingetragen. Das Reaktionsgemisch wird dann eine Stunde nachgerührt und anschliessend wasserdampfdestilliert. Das Destillat wird mit Diethylether extrahiert. Die Etherlösung wird mit Natriumsulfat getrocknet, filtriert und im Vacuum eingeengt. Man erhält 23,7 g eines schwach gelblichen Oels. Dieses wird bei 84-87°C im Vacuum (21 mbar) fraktioniert destilliert. Man erhält 20,3 g (64 % der Theorie) eines farblosen Oels.

| Analyse: C₈H₉F₂N (157,16) | | | | |
|---|---|---|---|---|
| | C | H | F | N |
| ber.: | 61,14 | 5,77 | 24,17 | 8,91 % |
| gef.: | 60,9 | 5,7 | 24,3 | 9,0 % |

### Beispiel 10: 1-[2-(2,4-Difluorphenyl)ethyl]-1H-pyrrol

15,7 g (0,10 Mol) 2-(2,4-Difluorphenyl)-ethylamin werden in einem Autoklaven mit 13,2 g (0,10 Mol) 2,5-Dimethoxytetrahydrofuran während 2 Stunden auf 260°C erhitzt. Das Reaktionsgemisch wird nach dem Erkalten durch Vacuumdestillation gereinigt. Man erhält 17,2 g (83 % der Theorie) eines farblosen Oels, das bei 90-93°C bei 0,033 mbar siedet.

| Analyse: C₁₂H₁₁F₂N (207,23) | | | | |
|---|---|---|---|---|
| | C | H | F | N |
| ber.: | 69,56 | 5,35 | 18,34 | 6,76 % |
| gef.: | 69,8 | 5,3 | 18,2 | 7,1 % |

### Beispiel 11: 3-(2,4-Difluorphenyl)-propannitril

74,0 g (0,40 Mol) 3-(2,4-Difluorphenyl)-propanamid werden mit 124 g (0,87 Mol) Phosphorpentoxid vermischt und in einem Kolben mit absteigendem Kühler im Oelbad auf 200°C erhitzt. Die entstehende Flüssigkeit wird durch Anlegen eines Vacuums von ca. 67 mbar abdestilliert. Man erhält 48,5 g eines farblosen Oels, das bei 120-124°C im Vacuum (19 mbar) fraktioniert destilliert wird. Man erhält 46,5 g (70 % der Theorie) des erwarteten Produktes.

| Analyse: C₉H₇F₂N (167,16) | | | | |
|---|---|---|---|---|
| | C | H | F | N |
| ber.: | 64,67 | 4,22 | 22,73 | 8,38 % |
| gef.: | 64,7 | 4,2 | 22,8 | 8,5 % |

### Beispiel 12: 3-(2,4-Difluorphenyl)-propylamin

33,4 g (0,20 Mol) 3-(2,4-Difluorphenyl)-propannitril werden in 200 ml Ethanol gelöst und in einem Druckreaktor nach Zugabe von 2,8 g Raney-Nickel in Ethanol und nach Aufpressen von 34 g (2,0 Mol) Ammoniakgas bei 75-80°C mit Wasserstoffgas hydriert. Die Wasserstoffaufnahme ist nach ca. 3 Stunden beendet. Das Reaktionsgemisch wird nach dem Erkalten, Entspannen und Filtrieren am Vacuumrotationsverdampfer vom Lösungsmittel befreit. Das erhaltene Oel wird bei 89-90°C im Vacuum (13 mbar) fraktioniert destilliert. Man erhält 26,0 g (76 % der Theorie) eines farblosen Oels.

| Analyse: C₉H₁₁F₂N (171,19) | | | | |
|---|---|---|---|---|
| | C | H | F | N |
| ber.: | 63,15 | 6,48 | 22,20 | 8,18 % |
| gef.: | 63,6 | 6,5 | 22,3 | 8,3 % |

### Beispiel 13: 1-[3-(2,4-Difluorphenyl)propyl]-1H-pyrrol

17,1 g (0,10 Mol) 3-(2,4-Difluorphenyl)-propylamin werden in einem Autoklaven mit 13,2 g (0,10 Mol) 2,5-Dimethoxytetrahydrofuran während 2 Stunden auf 260°C erhitzt. Das Reaktionsgemisch wird nach dem Erkalten durch Vacuumdestillation gereinigt. Man erhält 10,6 g (48 % der Theorie) eines farblosen Oels, das bei 80°C und 0,2 mbar oder 146-147°C und 15 mbar siedet.

| Analyse: C₁₃H₁₃F₂N (221,26) | | | | |
|---|---|---|---|---|
| | C | H | F | N |
| ber.: | 70,58 | 5,92 | 17,17 | 6,33 % |
| gef.: | 70,7 | 6,0 | 17,4 | 6,5 % |

### Beispiel 14: N-Benzylidene-2,4-difluorbenzylamin

50,2 g (0,35 Mol) 2,4-Difluorbenzylamin und 37,1 g (0,35 Mol) Benzaldehyd werden in 140 ml Toluol gelöst und auf Rückfluss geheizt. Das entstehende Wasser wird mit einem Wassersabscheider abgetrennt. Nach zwei Stunden ist die Reaktion beendet (GC-Kontrolle). Die Lösung wird am Vacuumrotationsverdampfer eingeengt. Man erhält 78,9 g (97 % der Theorie) einer leicht gelben Flüssigkeit.

| Analyse: C₁₄H₁₁F₂N (231,25) | | | |
|---|---|---|---|
| | C | H | N |
| ber.: | 72,72 | 4,79 | 6,06 % |
| gef.: | 72,69 | 4,84 | 6,01 % |

### Beispiel 15: 3-Chlor-2,2-dimethyl-N-[(2,4-difluorphenyl)methyl]propanamid

28,6 g (0,20 Mol) 2,4-Difluorbenzylamin und 19,0 g (0,24 Mol) Pyridin werden in 100 ml Toluol gelöst. Zu dieser Lösung werden bei 20-25°C 34,1 g (0,22 Mol) Chlorpivaloylchlorid innerhalb 15 Minuten unter Eisbadkühlung zugetropft. Es bildet sich eine Suspension, die bis ans Ende der Reaktion (GC-Kontrolle) noch drei Stunden bei Raumtemperatur nachgerührt wird. Zur Aufarbeitung wird mit 50 ml 2N Salzsäure auf pH 1 bis 2 eingestellt. Die entstandene weisse Emulsion wird dreimal mit 100 ml Toluol extrahiert. Das Extrakt wird mit 100 ml Wasser gewaschen, mit Magnesiumsulfat getrocknet und am Vacuumrotationsverdampfer eingeengt. Man erhält 49,2 g (94 % der Theorie) eines gelben Oels.

| Analyse: C₁₂H₁₄F₂ClNO (261,70) | | | | |
|---|---|---|---|---|
| | C | H | N | Cl |
| ber.: | 55,08 | 5,39 | 5,35 | 13,55 % |
| gef.: | 54,87 | 5,37 | 4,92 | 13,94 % |

### Beispiel 16: 3,3-Dimethyl-1-[(2,4-difluorphenyl)methyl]-2-azetidinon

49,7 g (0,19 Mol) 3-Chlor-2,2-dimethyl-N[(2,4-difluorphenyl)methyl]propanamid und 78,8 g (0,57 Mol) Kaliumcarbonat werden in 200 ml Methylethylketon suspendiert, erwärmt und 24 Stunden bei 75°C gerührt. Nach beendeter Reaktion (GC-Kontrolle) wird filtriert und das Filtrat am Vacuumrotationsverdampfer eingeengt. Man erhält 40,9 g (95 % der Theorie) eines gelben Oels.

| Analyse: C₁₂H₁₃F₂NO (225,24) | | | |
|---|---|---|---|
| | C | H | N |
| ber.: | 63,99 | 5,82 | 6,22 % |
| gef.: | 63,38 | 5,94 | 5,91 % |

### Beispiel 17: N-Hexyl-2,4-difluorbenzylamin

In einem 11 Autoklav werden 71,6 g (0,50 Mol) 2,4-Difluorbenzylamin, 100,2 g (1,0 Mol) Capronaldehyd, 1,0 g Essigsäure, 10 g Raney-Nickel in Ethanol und 500 ml Tetrahydrofuran vorgelegt. Diese Mischung wird auf 100°C geheizt und unter Rühren und unter 100 bar Druck hydriert. Die Wasserstoffaufnahme beträgt nach 13 Stunden 142 % der Theorie. Die schwarze Suspension wird filtriert und das Filtrat am Rotationsverdampfer eingeengt und anschliessend bei 77°C und 2 mbar destilliert. Man erhält 33,1 g einer farblosen Flüssigkeit.

| Analyse: C₁₃H₁₉F₂N (227,30) | | | |
|---|---|---|---|
| | C | H | N |
| ber.: | 68,70 | 8,43 | 6,16 % |
| gef.: | 68,31 | 8,40 | 5,63 % |

### Beispiel 18: N-[(2,4-Difluorphenyl)methyl]-N-hexyl-2,2-dimethyl-pentanamid

22,7 g (0.10 Mol) N-Hexyl-2,4-difluorbenzylamin und 24,3 g (0,24 Mol) Triethylamin werden in 150 ml Diethylether gelöst. Dazu wird bei Raumtemperatur eine Lösung von 17,8 g (0,12 Mol) 2,2-Dimethylpentansäurechlorid in 50 ml Diethylether in 30 Minuten getropft. Es wird während 18 Stunden bei Raumtemperatur nachgerührt, bis die Reaktion beendet ist (GC-Kontrolle). Zur Aufarbeitung wird die entstandene Suspension mit 70 ml 2H Salzsäure auf pH 7 eingestellt. Es löst sich alles und es entstehen zwei Phasen, die getrennt werden. Die organische Phase wird mit 50 ml Wasser nachgewaschen, mit Magnesiumsulfat getrocknet, filtriert und am Vacuumrotationsverdampfer eingeengt. Man erhält 37,8 g hellgelbe Flüssigkeit, die fraktioniert destilliert wird. Man gewinnt 21,4 g (63 % der Theorie) farbloses Oel, das bei 126-127°C und 0,4 mbar siedet.

| Analyse: C₂₀H₃₁F₂NO (339,47) | | | |
|---|---|---|---|
| | C | H | N |
| ber.: | 70,76 | 9,20 | 4,13 % |
| gef.: | 70,60 | 9,39 | 4,20 % |

### B) Herstellung der Titanocene

### Beispiel 19: Bis(cyclopentadienyl)-bis[2,6-difluor-3-(2-(1H-pyrr-1-yl-ethyl)phenyl]-titan

In einem 100 ml Schlenkrohr werden unter Argon als Schutzgas 2,5 g (0,010 Mol) Bis(cyclopentadienyl)-titandichlorid und 4,6 g (0,022 Mol) 1-[2-(2,4-Difluorphenyl)ethyl]-1H-pyrrol in 30 ml frisch destilliertem, absolutem Tetrahydrofuran vorgelegt und auf -20°C gekühlt. In diese rote Suspension wird unter Rühren bei -20°C in 30 Minuten eine Lösung von Lithiumdiisopropylamid zugetropft, hergestellt in einem 50 ml Schlenkrohr unter Argon aus 3,1 ml (0,022 Mol) Diisopropylamin in 15 ml absolutem Tetrahydrofuran und 13,7 ml (0,022 Mol) 1,6-molarer Butyllithiumlösung in Hexan bei -10°bis 0°C. Die braunrote Lösung wird noch während 2 Stunden bei -20°C nachgerührt. Nach dieser Zeit ist die Reaktion gemäss der Kontrolle durch ein Dünnschichtchromatogramm beendet. Die Lösung wird nun auf ein Gemisch von 100 ml Essigester, 100 ml Wasser und 1,3 g (0,022 Mol) Essigsäure gegossen und verrührt. Die orange Suspension wird über Hyflo filtriert. Die beiden Phasen des Filtrates werden voneinander getrennt. Die organische Phase wird mit Magnesiumsulfat getrocknet und im Vacuumrotationsverdampfer bei 20 mbar und 50°C Wasserbadtemperatur eingeengt. Man erhält 7,9 g eines dunkelroten Oels, das durch Flashchromatographie mit Hexan-Essigester (9:1) als Lösungsmittel gereinigt wird. Man erhält 3,3 g eines orangeroten glasigen Harzes.

| Analyse: C₃₄H₃₀F₄N₂Ti (590,52) | | | |
|---|---|---|---|
| | C | H | N |
| ber.: | 69,16 | 5,12 | 4,74 % |
| gef.: | 68,5 | 5,2 | 4,6 % |

### Beispiel 20: Bis(cyclopentadienyl)-bis[2,6-difluor-3-(3-(1H-pyrr-1-yl)-propyl)phenyl]-titan

Analog Beispiel 19 werden 2,5 g (0,010 Mol) Bis(cyclopentadienyl)-titandichlorid und 4,9 g (0,022 Mol) 1-[3-(2,4-Difluorphenyl)propyl]-1H-pyrrol mit 0,022 Mol Lithiumdiisopropylamidlösung umgesetzt. Das braunorange Oel wird mittels Flashchromatographie mit Hexan-Essigester (9:1) als Lösungsmittel gereinigt. Man erhält 2,3 g eines orangen glasigen Harzes.

| Analyse: C₃₆H₃₄F₄N₂Ti (618,57) | | | |
|---|---|---|---|
| | C | H | N |
| ber.: | 69,90 | 5,54 | 4,54 % |
| gef.: | 69,4 | 5,6 | 4,3 % |

### Beispiel 21: Bis(cyclopentadienyl)-bis[2,6-difluor-3-((1H-pyrr-1-yl)methyl)phenyl]-titan

Analog Beispiel 19 werden 2,5 g (0,010 Mol) Bis(cyclopentadienyl)-titandichlorid und 4,25 g (0,022 Mol) 1-[(2,4-Difluorphenyl)methyl]-1H-pyrrol mit 0,022 Mol Lithiumdiisopropylamidiösung umgesetzt. Man erhält 3,1 g an orangen Kristallen vom Schmelzpunkt 192-194°C.

| Analyse: C₃₂H₂₆F₄N₂Ti (562,46) | | | |
|---|---|---|---|
| | C | H | N |
| ber.: | 68,33 | 4,66 | 4,98 % |
| gef.: | 68,4 | 4,7 | 5,0 % |

### Beispiel 22: Bis(methylcyclopentadienyl)-bis[2,6-difluor-3-((1H-pyrr-1-yl)methyl)phenyl]-titan

Analog Beispiel 19 werden 2,77 g (0,010 Mol) Bis(methylcyclopentadienyl)-titandichlorid und 4,25 g (0,022 Mol) 1-[(2,4-Difluorphenyl)methyl]-1H-pyrrol mit 0,022 Mol Lithiumdiisopropylamidlösung umgesetzt. Man erhält 7,2 g eines dunkelroten Oels, aus dem durch Umkristallisation in Ethanol 3,6 g an orangen Kristallen, die bei 112-115°C schmelzen, gewonnen werden.

| Analyse: C₃₄H₃₀F₄N₂Ti (590,52) | | | |
|---|---|---|---|
| | C | H | N |
| ber.: | 69,16 | 5,12 | 4,74 % |
| gef.: | 69,1 | 5,2 | 4,6 % |

### Beispiel 23: Bis(cyclopentadienyl)-bis[2,6-difluor-3-((2,5-dimethyl-1H-pyrr-1-yl)methyl)phenyl]-titan

Analog Beispiel 19 werden 2,5 g (0,010 Mol) Bis(cyclopentadienyl)-titandichlorid und 4,9 g (0,022 Mol) 2,5-Dimethyl-1-[(2,4-difluorphenyl)methyl]-1H-pyrrol mit 0,022 Mol Lithiumdiisopropylamidlösung umgesetzt. Man erhält 7,1 g eines orangen Oels, das mittels Flashchromatographie mit Hexan-Essigester (3:1) als Laufmittel gereinigt wird. Man erhält 2,5 g eines orangen glasigen Harzes.

| Analyse: C₃₆H₃₄F₄N₂Ti (618,57) | | | |
|---|---|---|---|
| | C | H | N |
| ber.: | 69,90 | 5,54 | 4,53 % |
| gef.: | 69,6 | 5,9 | 4,2 % |

### Beispiel 24: Bis(cyclopentadienyl)-bis[2,6-difluor-3-((N-hexyl-(2,2-dimethylpentanoyl)amino)methyl)phenyl]-titan

Analog Beispiel 19 werden 2,5 g (0,010 Mol) Bis(cyclopentadienyl)-titandichlorid und 7,5 g (0,022 Mol) N-[(2,4-difluorphenyl)methyl]-N-hexyl-2,2-dimethylpentanamid mit 0,022 Mol Lithiumdiisopropylamidlösung umgesetzt. Das orange Oel wird mittels Flashchromatographie mit Hexan-Essigester (9:1) als Lösungsmittel gereinigt. Man erhält 1,8 g eines orangen Harzes.

| Analyse: C₅₀H₇₀F₄N₂O₂Ti (855,00) | | | |
|---|---|---|---|
| | C | H | N |
| ber.: | 70,24 | 8,25 | 3,28 % |
| gef.: | 69,76 | 8,44 | 3,32 % |

### C) Anwendungsbeispiele

### Beispiel 25: Photohärtung eines Acrylat-Gemisches

Es wird eine photohärtbare Zusammensetzung hergestellt durch Mischen der folgenden Komponenten:

| | | Feststoffgehalt |
|---|---|---|
| 150,30 g | Scripset 540¹⁾ (30 %-ige Lsg. in Aceton) | 45,1 g |
| 48,30 g | Trimethylolpropantriacrylat | 48,3 g |
| 6,60 g | Polyethylenglykoldiacrylat | 6,6 g |
| 0,08 g | Kristallviolett | |
| 205,28 g | | 100,0 g |

| | | |
|---|---|---|
| ¹⁾ Polystyrol-Maleinsäureanhydrid-Copolymer (Monsanto) | | |

Portionen dieser Zusammensetzung werden mit jeweils 0,3 % (bezogen auf den Feststoffgehalt) an Photoinitiator vermischt. Alle Operationen werden unter Rotlicht oder Gelblicht ausgeführt.

Die mit Initiator versetzten Proben werden in einer Stärke von 150 »m auf 200 »m Aluminiumfolie (10 x 15 cm) aufgetragen. Das Lösungsmittel wird durch Erwärmung auf 60°C während 15 Minuten im Umluftofen entfernt. Auf die flüssige Schicht wird eine 76 »m dicke Polyesterfolie gelegt und auf diese ein standardisiertes Testnegativ mit 21 Stufen verschiedener optischer Dichte (Stouffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 10 Sekunden, einer zweiten Testreihe 20 Sekunden und einer dritten Testreihe 40 Sekunden. Nach der Belichtung werden die Folien und die Maske entfernt, die belichtete Schicht in einem Ultraschallbad 120 Sekunden mit Entwickler A entwickelt und anschliessend bei 60° 15 Minuten im Umluftofen getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 1 angegeben. Entwickler A enthält 15 g Natriummetasilikat·H₂O; 0,16 g KOH; 3 g Polyethylenglykol 6000; 0,5 g Lävulinsäure und 1000 g deionisiertes Wasser.

**Tabelle 1**

| Titanocen Beispiel | Zahl der abgebildeten Stufen nach | | |
|---|---|---|---|
| | 10s | 20s | 40s Belichtung |
| 19 | 11 | 14 | 17 |
| 20 | 10 | 14 | 17 |
| 21 | 11 | 13 | 16 |
| 22 | 8 | 11 | 13 |
| 23 | 8 | 10 | 12 |
| 24 | 8 | 11 | 12 |

### Beispiel 26: Photohärtung eines Monomer-Polymer-Gemisches

Es wird eine photohärtbare Zusammensetzung hergestellt durch Mischen der folgenden Komponenten:
37,64 g Sartomer SR 444 (Pentaerythritol-triacrylat) (Sartomer Company, Westchester)
10,76 g Cymel 301 Hexamethoxymethylmelamin (Cyanamid)
47,30 g Carboset 525 (Thermoplastisches Polyacrylat mit
Carboxylgruppen/B.F. Goodrich)
4,30 g Polyvinylpyrrolidon PVP (GAF)
1̅0̅0̅,̅0̅ g̅
100,00 g der obigen Mischung
0,50 g Irgalitgrün GLN
319,00 g Methylenchlorid
30,00 g Methanol
4̅5̅0̅,̅0̅0̅ g̅
Portionen dieser Zusammensetzung werden mit jeweils 0,3 % (bezogen auf Feststoff) der in der folgenden Tabelle angegebenen Titanocene vermischt. Alle Operationen werden unter Rotlicht oder Gelblicht ausgeführt.

Die mit Initiator versetzten Proben werden in einer Stärke von 200 »m auf 200 »m Aluminiumfolie (10 x 15 cm) aufgetragen. Das Lösungsmittel wird durch Erwärmung auf 60°C während 15 Minuten im Umluftofen entfernt. Auf die flüssige Schicht wird eine 76 »m dicke Polyesterfolie gelegt und auf diese ein standardisiertes Testnegativ mit 21 Stufen verschiedener optischer Dichte (Stouffer-Keil) gelegt. Darüber wird eine zweite Polyesterfolie gelegt und das so erhaltene Laminat auf einer Metallplatte fixiert. Die Probe wird dann mit einer 5 KW-Metallhalogenid-Lampe im Abstand von 30 cm belichtet und zwar in einer ersten Testreihe 10 Sekunden, in einer zweiten Testreihe 20 Sekunden und in einer dritten Testreihe 40 Sekunden. Nach der Belichtung werden die Folien und die Maske entfernt, die belichtete Schicht in einem Ultraschallbad 240 Sekunden mit Entwickler A entwickelt und anschliessend bei 60° 15 Minuten im Umluftofen getrocknet. Die Empfindlichkeit des verwendeten Initiatorsystems wird durch die Angabe der letzten klebefrei abgebildeten Keilstufe charakterisiert. Je höher die Zahl der Stufen ist, desto empfindlicher ist das System. Eine Erhöhung um zwei Stufen bedeutet dabei etwa eine Verdopplung der Härtungsgeschwindigkeit. Die Ergebnisse sind in Tabelle 2 angegeben.

**Tabelle 2**

| Titanocen Beispiel | Zahl der abgebildeten Stufen nach | | |
|---|---|---|---|
| | 10s | 20s | 40s Belichtung |
| 19 | 12 | 14 | 17 |
| 20 | 11 | 14 | 17 |
| 21 | 12 | 15 | 18 |
| 22 | 9 | 11 | 14 |
| 23 | 11 | 13 | 16 |

## Patentansprüche

1. Titanocene der Formel I, 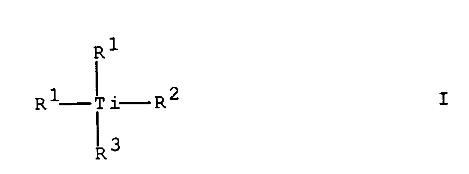 worin beide R¹ unabhängig voneinander unsubstituiertes oder ein- oder mehrfach durch C₁-C₁₈-Alkyl, C₁-C₁₈-Alkoxy, C₂-C₁₈-Alkenyl, C₅-C₈-Cyclo-alkyl, C₆-C₁₆-Aryl, C₇-C₁₆-Aralkyl, -Si(R⁴)₃, -Ge(R⁴)₃, Cyano oder Halogen substituiertes Cyclopentadienyl^{⊖}, Indenyl^{⊖} oder 4,5,6,7-Tetrahydroindenyl^{⊖} bedeuten und R⁴ C₁-C₁₂-Alkyl, C₅-C₁₂-Cycloalkyl, C₆-C₁₀-Aryl oder C₇-C₁₆-Aralkyl bedeutet, R² einen 6-gliedrigen carbocyclischen oder 5- oder 6-gliedrigen heterocyclischen aromatischen Ring bedeutet, der mindestens in den beiden ortho-Stellungen zur Titankohlenstoffbindung mit Fluoratomen substituiert ist und wobei der aromatische Ring weitere Substituenten enthalten kann und R³ unabhängig die Bedeutung von R² hat, wobei die Titanocene dadurch gekennzeichnet sind, dass R² und R³ durch einen Rest der Formel II, IIa oder IIb substituiert sind, 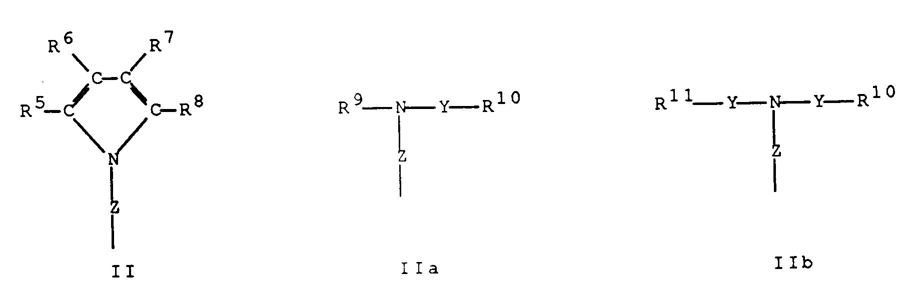 worin R⁵, R⁶, R⁷ und R⁸ unabhängig voneinander Wasserstoff, unsubstituiertes oder mit C₂-C₈-Dialkylamino, Bis[2-(C₁-C₄-alkoxy)ethyl]amino, Morpholino, Piperidino, N-Methylpiperazino, Pyrrolidino, quaternärem C₃-C₁₀-Trialkylammonium, C₁-C₁₂-Alkoxy, 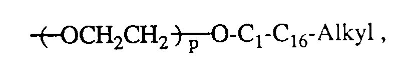 worin p eine Zahl von 1 bis 20 ist, 1,3-Dioxolan-2-yl-, 4-Methyl-1,3-dioxolan-2-yl, -OCH₂CH₂O-, C₂-C₁₂-Alkoxycarbonyl, C₂-C₁₂-Alkanoyloxy, C₂-C₁₂-Alkanoyl, C₁-C₁₂-Alkylthio, Halogen, Cyano oder -Si(R⁴)₃ substituiertes lineares oder verzweigtes C₁-C₁₈-Alkyl, C₂-C₅-Alkenyl, C₇-C₉-Aralkyl, C₇-C₉-Alkaryl, C₈-C₁₀-Alkaralkyl, C₆-C₁₀-Aryl, 2-Furyl, C₅-C₈-Cycloalkyl, C₅-C₈-Cycloalkenyl, C₂-C₁₂-Alkanoyl, C₂-C₁₂-Alkoxycarbonyl, -CHO, -Si(R⁴)₃ oder -Ge(R⁴)₃ bedeuten, oder R⁵ und R⁶ und/oder R⁷ und R⁸ oder R⁶ und R⁷ jeweils zusammen -(CH₂)₃-, -(CH₂)₄-, -CH=CH-CH=CH-, -CH=CH-C(R¹²)=CH-, -CH₂OCH₂- oder -CH₂N(C₁-C₄-Alkyl)CH₂- sind, worin R¹² Hydroxyl, C₁-C₄-Alkoxy oder C₂-C₄-Alkanoyloxy bedeutet, Y eine Gruppe -CO-, -CS-, -COO-, -SO₂- oder -Si(R⁴)₂- bedeutet, R⁹ Wasserstoff, lineares oder verzweigtes C₁-C₂₀-Alkyl, C₂-C₂₀-Alkenyl, C₃-C₈-Cycloalkyl, C₄-C₂₀-Cycloalkylalkyl, C₄-C₂₀-Alkylcycloalkyl, C₅-C₂₀-Alkylcycloalkylalkyl, C₆-C₂₀-Cycloalkenylalkyl, C₆-C₁₄-Aryl, C₇-C₂₀-Aralkyl, C₇-C₂₀-Alkaryl, C₈-C₂₀-Alkaralkyl oder C₃-C₁₂-Trialkylsilyl darstellt, wobei diese Reste unsubstituiert oder durch C₁-C₁₈-Alkoxy, C₁-C₁₈-Alkylthio, C₁-C₁₈-Alkylsulfonyl, C₆-C₁₀-Arylsulfonyl, C₇-C₂₀-Alkarylsulfonyl, 2-Tetrahydrofuranyl oder Cyano substituiert sind, R¹⁰ eine der für R⁹ gegebenen Bedeutungen hat oder C₁-C₂₀-Halogenalkyl, durch -CO- unterbrochenes C₂-C₂₀-Alkyl oder durch -COOH oder -COOR⁴ substituiertes C₁-C₁₂-Alkyl ist und im Falle, dass Y -CO-, -CS- oder -SO₂- ist, auch -NR¹³R¹⁴ bedeuten kann, worin R¹³ und R¹⁴ unabhängig voneinander eine der für R⁹ gegebenen Bedeutungen haben oder R¹³ und R¹⁴ zusammen C₃-C₇-Alkylen bedeuten, das durch -O-, -S- oder -N(R¹⁵)- unterbrochen sein kann, worin R¹⁵ Wasserstoff, C₁-C₁₂-Alkyl, C₃-C₁₂-Alkenyl, C₇-C₁₂-Aralkyl oder C₂-C₂₀-Alkanoyl bedeutet, oder R⁹ und R¹⁰ zusammen lineares oder verzweigtes C₂-C₈-Alkylen oder durch Halogen, C₁-C₄-Alkoxy, Allyloxy oder -NR¹³R¹⁴ substituiertes C₂-C₈-Alkylen oder einen zweiwertigen Rest der Formel 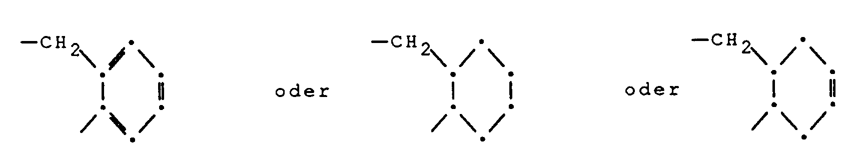 bedeuten, R¹¹ eine der für R¹⁰ gegebenen Bedeutungen hat oder R¹¹ und R¹⁰ zusammen C₁-C₈-Alkandiyl, C₂-C₈-Alkendiyl, C₆-C₁₄-Arendiyl, C₄-C₁₂-Cycloalkandiyl, C₅-C₁₂-Cycloalkendiyl, C₆-C₁₄-Cycloalkadiendiyl, C₇-C₂₀-Bicycloalkandiyl, C₇-C₂₀-Bicycloalkendiyl oder durch -O-, -S- oder -N(R¹⁵)- unterbrochenes C₂-C₄-Alkandiyl bedeuten, wobei diese Reste unsubstituiert oder durch einen oder mehrere der Substituenten Halogen, C₁-C₁₀-Alkoxy, C₁-C₂₀-Alkyl, C₃-C₂₀-Alkenyl oder C₆-C₁₄-Aryl substituiert sind, und
Z unsubstituiertes oder durch -COOR⁴, -CN oder Halogen substituiertes C₁-C₂₀-Alkandiyl bedeutet.

2. Titanocene gemäss Anspruch 1, dadurch gekennzeichnet, dass R¹ Cyclopentadienyl^{⊖} oder Methylcyclopentadienyl^{⊖}, insbesondere Cyclopentadienyl^{⊖}, ist.

3. Titanocene gemäss Anspruch 1, dadurch gekennzeichnet, dass R² und R³ die gleiche Bedeutung haben.

4. Titanocene gemäss Anspruch 1, dadurch gekennzeichnet, dass R² und R³ für 2,6-Difluorphen-1-yl stehen, an das ein Rest der Formel II, IIa oder IIb gebunden ist, und das weitere 1 oder 2 gleiche oder verschiedene Substituenten enthalten kann.

5. Titanocene gemäss Anspruch 4, dadurch gekennzeichnet, dass in Formel I beide R¹ Cyclopentadienyl^{⊖} und R² und R³ Reste der Formel III 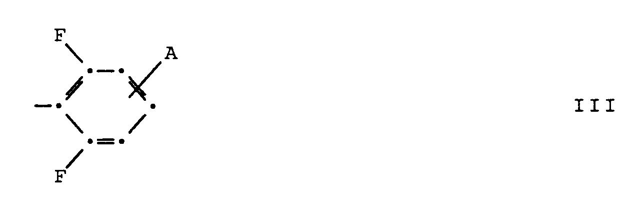 bedeuten, worin A eine Gruppe der Formel II, IIa oder IIb bedeutet.

6. Titanocene gemäss Anspruch 1, dadurch gekennzeichnet, dass R² und R³ durch einen Rest der Formel II substituiert sind.

7. Titanocene gemäss Anspruch 6, dadurch gekennzeichnet, dass R⁵, R⁶, R⁷ und R⁸ unabhängig voneinander Wasserstoff, unsubstituiertes oder durch C₂-C₈-Dialkylamino, Bis(2-methoxyethyl)amino, Morpholino, Piperidino, C₁-C₁₂-Alkoxy, 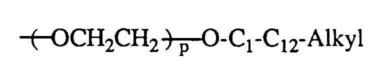 mit p = 1-3, 1,3-Dioxolan-2-yl, -OCH₂CH₂O-, C₂-C₈-Alkanoyloxy, C₁-C₈-Alkoxycarbonyl, Halogen, Cyano, C₁-C₄-Alkylthio oder -Si(CH₃)₃ substituiertes C₁-C₁₂-Alkyl, C₂-C₅-Alkenyl, C₇-C₉-Phenylalkyl, C₇-C₁₀-Alkylphenyl, Phenyl, 2-Furyl, C₅- oder C₆-Cycloalkyl, C₅- oder C₆-Cycloalkenyl, C₂-C₈-Alkanoyl, C₂-C₅-Alkoxycarbonyl, -CHO oder -Si(R⁴)₃ bedeuten, worin R⁴ C₁-C₈-Alkyl oder Phenyl ist, und Z unsubstituiertes C₁-C₈-Alkandiyl bedeutet.

8. Titanocene gemäss Anspruch 6, dadurch gekennzeichnet, dass R⁵, R⁶, R⁷ und R⁸ unabhängig voneinander Wasserstoff, unsubstituiertes oder durch C₂-C₈-Dialkylamino, Morpholino, C₁-C₄-Alkoxy, 1,3-Dioxolan-2-yl oder Cyano substituiertes C₁-C₈-Alkyl, C₂-C₄-Alkenyl, Phenyl, 2-Furyl oder -Si(R⁴)₃ bedeuten, worin R⁴ C₁-C₄-Alkyl ist, und Z unsubstituiertes C₁-C₄-Alkandiyl bedeutet.

9. Titanocene gemäss Anspruch 6, dadurch gekennzeichnet, dass R⁵, R⁶, R⁷ und R⁸ unabhängig voneinander Wasserstoff oder C₁-C₄-Alkyl sind.

10. Titanocene gemäss Anspruch 1, dadurch gekennzeichnet, dass R² und R³ durch eine Gruppe der Formel IIa substituiert sind, worin Y -CO-, -CS-, -COO- oder - SO₂- bedeutet, R⁹ Wasserstoff, unsubstituiertes oder durch C₁-C₁₂-Alkoxy oder Tetrahydrofuryl substituiertes C₁-C₁₂-Alkyl, C₂-C₅-Alkenyl, C₅-C₈-Cycloalkyl, C₆-C₁₈-Cycloalkylalkyl, C₆-C₁₈-Alkylcycloalkyl, C₇-C₁₈-Alkylcycloalkylalkyl, C₇-C₁₆-Aralkyl oder C₈-C₁₆-Alkaralkyl bedeutet, R¹⁰ eine der für R⁹ gegebenen Bedeutungen hat oder C₆-C₁₀-Aryl, C₆-C₁₀-Halogenaryl, C₇-C₁₈-Alkaryl oder C₁-C₁₂-Halogenalkyl bedeutet, oder im Falle, dass Y -CO- oder -SO₂-bedeutet, R¹⁰ auch -NR¹³R¹⁴ bedeutet, worin R¹³ und R¹⁴ unabhängig voneinander Wasserstoff, C₁-C₁₂-Alkyl, Phenyl, Benzyl oder Cyclohexyl bedeuten oder R¹³ und R¹⁴ zusammen C₄-C₅-Alkylen oder 3-Oxapentamethylen bedeuten, oder R⁹ und R¹⁰ zusammen C₂-C₈-Alkylen bedeuten, und Z unsubstituiertes C₁-C₈-Alkandiyl bedeutet.

11. Titanocene gemäss Anspruch 10, worin R⁹ Wasserstoff, C₁-C₈-Alkyl oder C₇-C₉-Aralkyl ist, R¹⁰ C₁-C₈-Alkyl, Trifluormethyl, Phenyl oder durch Halogen oder C₁-C₁₂-Alkyl substituiertes Phenyl bedeutet oder R⁹ und R¹⁰ zusammen C₂-C₆-Alkylen bedeuten, Y -CO- oder -SO₂- ist und Z unsubstituiertes C₁-C₄-Alkandiyl bedeutet.

12. Titanocene gemäss Anspruch 1, dadurch gekennzeichnet, dass R² und R³ durch eine Gruppe der Formel IIb substituiert sind, worin R¹⁰ und R¹¹ zusammen C₂-C₈-Alkandiyl, C₂-C₈-Alkendiyl, C₆-C₁₄-Arendiyl, Cyclohexandiyl oder C₇-C₁₂-Bicycloalkandiyl bedeuten, Y -CO- ist und Z unsubstituiertes C₁-C₄-Alkandiyl bedeutet.

13. Durch Strahlung polymerisierbare Zusammensetzung, enthaltend (a) mindestens eine nichtflüchtige, monomere, oligomere oder polymere Verbindung mit mindestens einer polymerisierbaren ethylenisch ungesättigten Doppelbindung und (b) mindestens ein Titanocen der Formel I nach Anspruch 1 als Photoinitiator und (c) gegebenenfalls mindestens einen zusätzlichen von (b) verschiedenen Photoinitiator.

14. Zusammensetzung gemäss Anspruch 13, enthaltend als Photoinitiator (c) ein Benzophenon, einen Benzoinalkylether, ein Benzilketal, ein 4-Aroyl-1,3-dioxolan, ein Dialkoxyacetophenon, ein α-Hydroxy- oder α-Aminoacetophenon oder ein α-Hydroxycycloalkylphenylketon oder Mischungen davon als zusätzlichen Photoinitiator.

15. Verwendung einer Zusammensetzung gemäss Anspruch 13 zur Herstellung von Lacken, Druckfarben, Druckplatten, Dentalmassen, Resistmaterialien sowie als Bildaufzeichnungsmaterial.

16. Beschichtetes Substrat, das auf mindestens einer Oberfläche mit einer Zusammensetzung gemäss Anspruch 13 beschichtet ist.

17. Verfahren zur photographischen Herstellung von Reliefabbildungen, dadurch gekennzeichnet, dass man ein beschichtetes Substrat gemäss Anspruch 16 bildmässig belichtet und die unbelichteten Anteile danach mit einem Lösungsmittel entfernt.

18. Verwendung von Titanocenen der Formel I gemäss Anspruch 1 alleine oder zusammen mit anderen Initiatoren als Photoinitiatoren für die Photopolymerisation von nichtflüchtigen monomeren, oligomeren oder polymeren Verbindungen mit mindestens einer polymerisierbaren ethylenisch ungesättigten Doppelbindung.

19. Photoinitiatorengemisch, enthaltend einen Photoinitiator vom Typ der Benzophenone, Benzoinalkylether, Benzilketale, 4-Aroyl-1,3-dioxolane, Dialkoxyacetophenone, α-Hydroxyacetophenone, α-Hydroxycycloalkylphenylketone, α-Aminoacetophenone oder Mischungen hiervon und ein Titanocen der Formel I gemäss Anspruch 1, bei einem Gewichtsverhältnis von 1:1 bis 30:1.

## Claims

1. A titanocene of the formula I 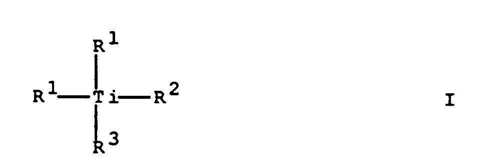 in which both the R¹ radicals, independently of one another, are cyclopentadienyl^{⊖}, indenyl^{⊖} or 4,5,6,7-tetrahydroindenyl^{⊖}, each of which is unsubstituted, monosubstituted or polysubstituted by C₁-C₁₈alkyl, C₁-C₁₈alkoxy, C₂-C₁₈alkenyl, C₅-C₈cycloalkyl, C₆-C₁₆aryl, C₇-C₁₆aralkyl, -Si(R⁴)₃, -Ge(R⁴)₃, cyano or halogen and R⁴ is C₁-C₁₂alkyl, C₅-C₁₂cycloalkyl, C₆-C₁₀aryl or C₇-C₁₆aralkyl, R² is a 6-membered carbocyclic or 5- or 6-membered heterocyclic aromatic ring which is substituted by fluorine atoms at least in the two ortho-positions to the titanium-carbon bond, and in which the aromatic ring may contain further substituents, and R³, independently, is as defined for R², R² and R³ in the titanocenes being substituted by a radical of the formula II, IIa or IIb 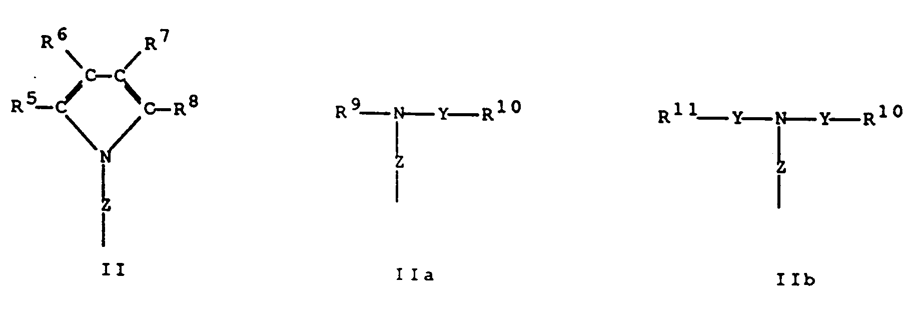 in which R⁵, R⁶, R⁷ and R⁸, independently of one another, are hydrogen or linear or branched C₁-C₁₈alkyl, C₂-C₅alkenyl, C₇-C₉aralkyl, C₇-C₉alkaryl, C₈-C₁₀alkaralkyl, C₆-C₁₀aryl, 2-furyl, C₅-C₈cycloalkyl, C₅-C₈cycloalkenyl, C₂-C₁₂alkanoyl, C₂-C₁₂alkoxycarbonyl, -CHO, -Si(R⁴)₃ or -Ge(R⁴)₃, these radicals being unsubstituted or substituted by C₂-C₈dialkylamino, bis[2-(C₁-C₄alkoxy)ethyl]amino, morpholino, piperidino, N-methylpiperazino, pyrrolidino, quaternary C₃-C₁₀trialkylammonium, C₁-C₁₂alkoxy, -(OCH₂CH₂)-ₚOC₁-C₁₆alkyl, in which p is a number from 1 to 20, 1,3-dioxolan-2-yl, 4-methyl-1,3-dioxolan-2-yl, -OCH₂CH₂O-, C₂-C₁₂alkoxycarbonyl, C₂-C₁₂alkanoyloxy, C₂-C₁₂alkanoyl, C₁-C₁₂alkylthio, halogen, cyano or -Si(R⁴)₃, or R⁵ and R₆ and/or R⁷ and R⁸ or R⁶ and R⁷ are each together -(CH₂)₃-, -(CH₂)₄-, -CH=CH-CH=CH-, -CH=CH-C(R¹²)=CH-, -CH₂OCH₂- or -CH₂N(C₁-C₄alkyl)CH₂-, in which R¹² is hydroxyl, C₁-C₄alkoxy or C₂-C₄alkanoyloxy, Y is a -CO-, -CS-, -COO-, -SO₂- or -Si(R⁴)₂- group, R₉ is hydrogen, linear or branched C₁-C₂₀alkyl, C₂-C₂₀alkenyl, C₃-C₈cycloalkyl, C₄-C₂₀cycloalkylalkyl, C₄-C₂₀alkylcycloalkyl, C₅-C₂₀alkylcycloalkylalkyl, C₆-C₂₀cycloalkenylalkyl, C₆-C₁₄aryl, C₇-C₂₀aralkyl, C₇-C₂₀alkaryl, C₈-C₂₀alkaralkyl or C₃-C₁₂trialkylsilyl, these radicals being unsubstituted or substituted by C₁-C₁₈alkoxy, C₁-C₁₈alkylthio, C₁-C₁₈alkylsulfonyl, C₆-C₁₀arylsulfonyl, C₇-C₂₀alkarylsulfonyl, 2-tetrahydrofuranyl or cyano, R¹⁰ has one of the meanings given for R⁹ or is C₁-C₂₀haloalkyl, C₂-C₂₀alkyl which is interrupted by -CO-, or is C₁-C₁₂alkyl which is substituted by -COOH or -COOR⁴, and in the case where Y is -CO-, -CS- or -SO₂-, may alternatively be -NR¹³R¹⁴ in which R¹³ and R¹⁴, independently of one another, have one of the meanings given for R⁹, or R¹³ and R¹⁴ together are C₃-C₇alkylene which may be interrupted by -O-, -S- or -N(R¹⁵)-, in which R¹⁵ is hydrogen, C₁-C₁₂alkyl, C₃-C₁₂alkenyl, C₇-C₁₂aralkyl or C₂-C₂₀alkanoyl, or R⁹ and R¹⁰ together are linear or branched C₂-C₈alkylene or C₂-C₈alkylene which is substituted by halogen, C₁-C₄alkoxy, allyloxy or -NR¹³R¹⁴, or are a divalent radical of the formula 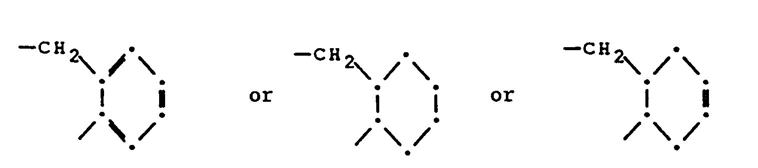 R¹¹ has one of the meanings given for R¹⁰, or R¹¹ and R¹⁰ together are C₁-C₈alkanediyl, C₂-C₈alkenediyl, C₆-C₁₄arenediyl, C₄-C₁₂cycloalkanediyl, C₅-C₁₂cycloalkenediyl, C₆-C₁₄cycloalkadienediyl, C₇-C₂₀bicycloalkanediyl, C₇-C₂₀bicycloalkenediyl, or C₂-C₄alkanediyl which is interrupted by - O-, -S- or -N(R¹⁵)-, these radicals being unsubstituted or substituted by one or more of the substituents halogen, C₁-C₁₀alkoxy, C₁-C₂₀alkyl, C₃-C₂₀alkenyl or C₆-C₁₄aryl, and Z is C₁-C₂₀alkanediyl which is unsubstituted or substituted by -COOR⁴, -CN or halogen.

2. A titanocene according to claim 1, wherein R¹ is cyclopentadienyl^{⊖} or methylcyclopentadienyl^{⊖}, in particular cyclopentadienyl^{⊖}.

3. A titanocene according to claim 1, wherein R² and R³ are identical.

4. A titanocene according to claim 1, wherein R² and R³ are 2,6-difluorophen-1-yl to which a radical of the formula II, IIa or IIb is bonded, and which may contain a further 1 or 2 identical or different substituents.

5. A titanocene according to claim 4, wherein, in the formula I, both R¹ groups are cyclopentadienyl^{⊖}, and R² and R³ are radicals of the formula III 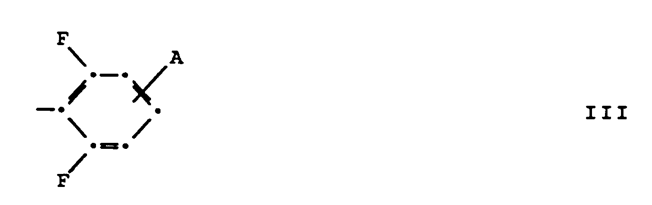 in which A is a group of the formula II, IIa or IIb.

6. A titanocene according to claim 1, wherein R² and R³ are substituted by a radical of the formula II.

7. A titanocene according to claim 6, wherein R⁵, R⁶, R⁷ and R⁸, independently of one another, are hydrogen, C₁-C₁₂alkyl, C₂-C₅alkenyl, C₇-C₉phenylalkyl, C₇-C₁₀alkylphenyl, phenyl, 2-furyl, C₅- or C₆cycloalkyl, C₅- or C₆cycloalkenyl, C₂-C₈alkanoyl, C₂-C₅alkoxycarbonyl, -CHO or -Si(R⁴)₃, in which R⁴ is C₁-C₈alkyl or phenyl, each of which is unsubstituted or substituted by C₂-C₈dialkylamino, bis(2-methoxyethyl)amino, morpholino, piperidino, C₁-C₁₂alkoxy, -(OCH₂CH₂)-ₚOC₁-C₁₂alkyl where p = 1-3, 1,3-dioxolan-2-yl, -OCH₂CH₂O-, C₂-C₈alkanoyloxy, C₁-C₈alkoxycarbonyl, halogen, cyano, C₁-C₄alkylthio or -Si(CH₃)₃, and Z is unsubstituted C₁-C₈alkanediyl.

8. A titanocene according to claim 6, wherein R⁵, R⁶, R⁷ and R⁸, independently of one another, are hydrogen, C₁-C₈alkyl, C₂-C₄alkenyl, phenyl, 2-furyl or -Si(R⁴)₃, in which R⁴ is C₁-C₄alkyl, each of which is unsubstituted or substituted by C₂-C₈dialkylamino, morpholino, C₁-C₄alkoxy, 1,3-dioxolan-2-yl or cyano, and Z is unsubstituted C₁-C₄alkanediyl.

9. A titanocene according to claim 6, wherein R⁵, R⁶, R⁷ and R⁸, independently of one another, are hydrogen or C₁-C₄alkyl.

10. A titanocene according to claim 1, wherein R² and R³ are substituted by a group of the formula IIa, in which Y is -CO-, -CS-, -COO- or - SO₂-, R⁹ is hydrogen, C₁-C₁₂alkyl, C₂-C₅alkenyl, C₅-C₈cycloalkyl, C₆-C₁₈cycloalkylalkyl, C₆-C₁₈alkylcycloalkyl, C₇-C₁₈alkylcycloalkylalkyl, C₇-C₁₆aralkyl or C₈-C₁₆alkaralkyl, each of which is unsubstituted or substituted by C₁-C₁₂alkoxy or tetrahydrofuryl, R¹⁰ has one of the meanings given for R⁹ or is C₆-C₁₀aryl, C₆-C₁₀haloaryl, C₇-C₁₈alkaryl or C₁-C₁₂haloalkyl, or in the case where Y is -CO- or -SO₂- R¹⁰ is alternatively -NR¹³R¹⁴, in which R¹³ and R¹⁴, independently of one another, are hydrogen, C₁-C₁₂alkyl, phenyl, benzyl or cyclohexyl, or R¹³ and R¹⁴ together are C₄-C₅alkylene or 3-oxapentamethylene, or R⁹ and R¹⁰ together are C₂-C₈alkylene, and Z is unsubstituted C₁-C₈alkanediyl.

11. A titanocene according to claim 10, in which R⁹ is hydrogen, C₁-C₈alkyl or C₇-C₉aralkyl, R¹⁰ is C₁-C₈alkyl, trifluoromethyl, phenyl or phenyl which is substituted by halogen or C₁-C₁₂alkyl, or R⁹ and R¹⁰ together are C₂-C₆alkylene, Y is -CO- or -SO₂-,and Z is unsubstituted C₁-C₄alkanediyl.

12. A titanocene according to claim 1, wherein R² and R³ are substituted by a group of the formula IIb in which R¹⁰ and R¹¹ together are C₂-C₈alkanediyl, C₂-C₈alkenediyl, C₆-C₁₄arenediyl, cyclohexanediyl or C₇-C₁₂bicycloalkanediyl, Y is -CO-, and Z is unsubstituted C₁-C₄alkanediyl.

13. A radiation-polymerizable composition containing (a) at least one non-volatile, monomeric, oligomeric or polymeric compound containing at least one polymerizable ethylenically unsaturated double bond, and (b) at least one titanocene of the formula I according to claim 1 as photoinitiator, and (c) if desired at least one additional photoinitiator which is different from (b).

14. A composition according to claim 13, containing, as photoinitiator (c), a benzophenone, a benzoin alkyl ether, a benzil ketal, a 4-aroyl-1,3-dioxolane, a dialkoxyacetophenone, an α-hydroxy-α-aminoacetophenone or an α-hydroxycycloalkyl phenyl ketone, or mixtures thereof, as additional photoinitiator.

15. The use of a composition according to claim 13 for the production of paints, printing inks, printing plates, dental materials, resist materials and as image-recording material.

16. A coated substrate which is coated on at least one surface with a composition according to claim 13.

17. A process for the photographic production of relief images, wherein a coated substrate according to claim 16 is exposed imagewise, and the unexposed areas are then removed using a solvent.

18. The use of titanocenes of the formula I according to claim 1 alone or together with other initiators as photoinitiators for the photopolymerization of non-volatile, monomeric, oligomeric or polymeric compounds containing at least one polymerizable ethylenically unsaturated double bond.

19. A photoinitiator mixture containing a photoinitiator of the benzophenone, benzoin alkyl ether, benzil ketal, 4-aroyl-1,3-dioxolane, dialkoxyacetophenone, α-hydroxyacetophenone, α-hydroxycycloalkyl phenyl ketone or α-aminoacetophenone type, or mixtures thereof, and a titanocene of the formula I according to claim 1, in a weight ratio of from 1:1 to 30:1.

## Revendications

1. Titanocènes de formule I 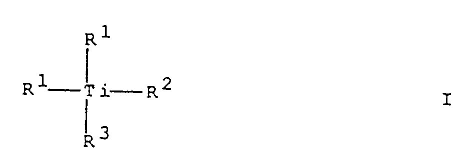 dans laquelle les deux radicaux R¹ signifient, indépendamment l'un de l'autre, un cyclopentadiényle^{⊖}, un indényle^{⊖} ou un 4,5,6,7-tétrahydroindényle^{⊖}, non substitué ou substitué une ou plusieurs fois par des alkyles en C₁-C₁₈, alcoxy en C₁-C₁₈, alcényle en C₂-C₁₈, cyclo-alkyle en C₅-C₈, aryle en C₆-C₁₆, aralkyle en C₇-C₁₆, -Si(R⁴)₃, - Ge(R⁴)₃, cyano ou halogène et le radical R⁴ signifie un alkyle en C₁-C₁₂, un cycloalkyle en C₅-C₁₂, un aryle en C₆-C₁₀ ou un aralkyle en en C₇-C₁₆ ; le radical R² signifie un cycle aromatique carbocyclique à 6 chaînons ou hétérocyclique à 5 ou 6 chaînons ; au moins substitué par des atomes de fluor sur les deux positions en ortho par rapport au carbone portant le titane, le cycle aromatique pouvant contenir d'autres substituants et le radical R³ a, indépendamment de R², la signification de R², les titanocènes étant caractérisés en ce que les radicaux R² et R³ sont substitués par un reste de formule II, IIa ou IIb, 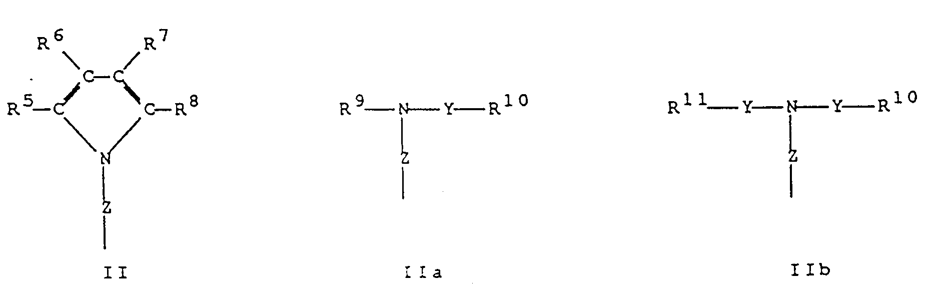 dans lesquelles les radicaux R⁵, R⁶, R⁷ et R⁸ signifient, indépendamment l'un de l'autre, un hydrogène, un -CHO, un - Si(R⁴)₃ ou un -Ge(R⁴)₃, un alcényle en C₂-C₅, un alkyle en C₁-C₁₈ linéaire ou ramifié, un aralkyle en C₇-C₉, un alkaryle en C₇-C₉, un alkaralkyle en C₈-C₁₀, un aryle en C₆-C₁₀, un 2-furyle, un cycloalkyle en C₅-C₈, un cycloalcényle en C₅-C₈, un alcanoyle en C₂-C₁₂, un alcoxycarbonyle en C₂-C₁₂, non substitués ou substitués par des dialkylamino en C₂-C₈, bis[2-(alcoxy en C₁-C₄)éthyl]amino, morpholino, pipéridino, N-méthylpipérazino, pyrrolidino, trialkylammonium quaternaire en C₃-C₁₀, alcoxy en C₁-C₁₂, - 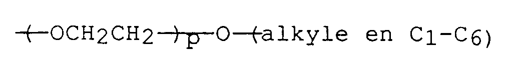 dans lequel p est un nombre compris entre 1 et 20, 1,3-dioxolan-2-yle, 4-méthyl-1,3-dioxolan-2-yle, -OCH₂CH₂O-, alcoxycarbonyle en C₂-C₁₂, alcanoyloxy en C₂-C₁₂, alcanoyle en C₂-C₁₂, alkylthio en C₁-C₁₂, halogène, cyano ou -Si(R⁴)₃ ; ou les radicaux R⁵ et R⁶ et/ou R⁷ et R⁸ ou R⁶ et R⁷ sont, ensemble dans tous les cas, les -(CH₂)₃-, -(CH₂)₄-, -CH=CH-CH=CH-, -CH=CH-C(R¹²)=CH-, -CH₂OCH₂- ou -CH₂N(alkyle en C₁-C₄)-CH₂-, dans lequel le radical R¹² signifie un hydroxyle, un alcoxy en C₁-C₄, ou un alcanoyloxy en C₂-C₄ ; Y signifie un groupe -CO-, -CS-, -COO-, -SO₂- ou -Si(R⁴)₂- ; le radical R⁹ représente un hydrogène, un alcényle en C₂-C₂₀, un alkyle en C₁-C₂₀ linéaire ou ramifié, un cycloalkyle en C₃-C₈, un cyclo-alkylalkyle en C₄-C₂₀, un alkylcycloalkyle en C₄-C₂₀, un alkylcycloalkylalkyle en C₅-C₂₀, un cycloalcénylalkyle en C₆-C₂₀, un aryle en C₆-C₁₄, un aralkyle en C₇-C₂₀, un alkaryle en C₇-C₂₀, un alkaralkyle C₈-C₂₀ ou un trialkylsilyle en C₃-C₁₂, ces restes étant non substitués ou substitués par des alcoxy en C₁-C₁₈, alkylthio en C₁-C₁₈, alkylsulfonyle en C₁-C₁₈, arylsulfonyle en C₆-C₁₀, alkarylsulfonyle en C₇-C₂₀, 2-tétrahydrofuranyle ou cyano ; le radical R¹⁰ a l'une des significations données au radical R⁹ ou est un halogénalkyle en C₁-C₂₀, un alkyle en C₂-C₂₀ interrompu par un -CO- ou un alkyle en C₁-C₁₂ substitué par -COOH ou -COOR⁴ et dans le cas où Y serait un -CO-, un -CS-ou un -SO₂-, il peut aussi signifier -NR¹³R¹⁴, les radicaux R¹³ et R¹⁴ ayant, indépendamment l'un de l'autre, une des significations données au radical R⁹ ou les radicaux R¹³ et R¹⁴ signifiant ensemble un alkylène en C₃-C₇ qui peut être interrompu par les -O-, -S- ou -N(R¹⁵)-, le radical R¹⁵ signifiant un hydrogène, un alkyle en C₁-C₁₂, un alcényle en C₃-C₁₂, un aralkyle en C₇-C₁₂ ou un alcanoyle en C₂-C₂₀ ; ou les radicaux R⁹ et R¹⁰ signifient, ensemble, un alkylène en C₂-C₈ linéaire ou ramifié, ou un alkylène en C₂-C₈ substitué par les halogène, alcoxy en C₁-C₄, allyloxy ou -NR¹³R¹⁴ ou un reste divalent de formule : 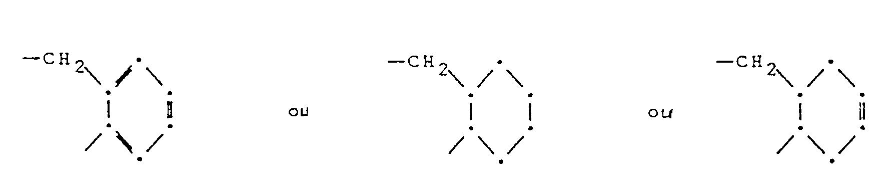 le radical R¹¹ a l'une des significations données à R¹⁰ ou les radicaux R¹¹ et R¹⁰, ensemble, signifient un alcanediyle en C₁-C₈ , un alcène-diyle en C₂-C₈ ,un arène-diyle en C₆-C₁₄ , un cycloalcane-diyle en C₄-C₁₂, un cycloalcènediyle en C₅-C₁₂, un cycloalcanediène-diyle en C₆-C₁₄ ,un bicycloalcane-diyle en C₇-C₂₀, un bicycloalcène-diyle en C₇-C₂₀ ou un alcane-diyle en C₂-C₄, interrompu par les -O-, -S- ou -N(R¹⁵)-, ces restes étant non substitués ou substitués par un ou plusieurs des substituants halogène, alcoxy en C₁-C₁₀, alkyle en C₁-C₂₀, alcényle en C₃-C₂₀ ou aryle en C₆-C₁₄ ; et Z signifie un alcane-diyle en C₁-C₂₀ non substitué ou substitué par les -COOR⁴, -CN ou halogène.

2. Titanocène selon la revendication 1, caractérisé en ce que le radical R¹ est un cyclopentadiényle^{⊖} ou un méthylcyclopentadiényle^{⊖}, en particulier un cyclopentadiényle.

3. Titanocène selon la revendication 1, caractérisé en ce que les radicaux R² et R³ ont la même signification.

4. Titanocène selon la revendication 1, caractérisé en ce que les radicaux R² et R³ sont un 2,6-difluorophèn-1-yle, sur lequel est lié un reste de formule II, IIa ou IIb et qui peut contenir 1 ou 2 autres substituants identiques ou différents.

5. Titanocène selon la revendication 4, caractérisé en ce que dans la formule I, les deux radicaux R¹ signifient un cyclopentadiényle^{⊖} et les radicaux R² et R³ un reste de formule III 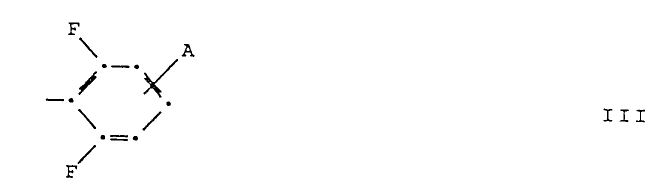 dans laquelle A signifie un groupe de formule II, IIa ou IIb.

6. Titanocène selon la revendication 1, caractérisé en ce que les substituants R² et R³ sont substitués par un reste de formule II.

7. Titanocène selon la revendication 6, caractérisé en ce que R⁵, R⁶, R⁷ et R⁸ signifient, indépendamment l'un de l'autre, un hydrogène ou un -CHO-, un -Si(R⁴)₃, dans lequel R⁴ est un alkyle en C₁-C₈ ou un phényle, un alcoxycarbonyle en C₂-C₅, un alcanoyle en C₂-C₈, un cycloalcényle en C₅ ou C₆, un cycloalkyle en C₅ ou C₆, un 2-furyle, un phényle, un alkylphényle en C₇-C₁₀, un phénylalkyle en C₇-C₉, un alcényle en C₂-C₅ ou un alkyle en C₁-C₁₂ non substitué ou substitué par les dialkylamino en C₂-C₈, bis(2-méthoxyéthyl)amino, morpholino, pipéridino, alcoxy en C₁-C₁₂, 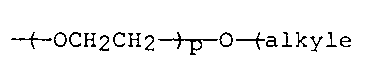 avec p valant de 1 à 3, 1,3-dioxolan-2-yle, -OCH₂CH₂O-, alcanoyloxy en C₂-C₈, alcoxycarbonyle en C₁-C₈, halogène, cyano, alkylthio en C₁-C₄ ou -Si(CH₃)₃, et Z signifie un alcanediyle en C₁-C₈ non substitué.

8. Titanocène selon la revendication 6, caractérisé en ce que R⁵, R⁶, R⁷ et R⁸ signifient, indépendamment l'un de l'autre, un hydrogène, un -Si(R⁴)₃, dans lequel R⁴ est un alkyle en C₁-C₄, un 2-furyle, un phényle, un alcényle en C₂-C₄, un alkyle en C₁-C₈ non substitué ou substitué par les dialkylamino en C₂-C₈, morpholino, alcoxy en C₁-C₄, 1,3-dioxolan-2-yle ou cyano.

9. Titanocène selon la revendication 6, caractérisé en ce que R⁵, R⁶, R⁷ et R⁸ sont, indépendamment l'un de l'autre, un hydrogène ou un alkyle en C₁-C₄.

10. Titanocène selon la revendication 1, caractérisé en ce que R² et R³ sont substitués par un reste de formule IIa, dans laquelle Y signifie un -CO-, un -CS-, un -COO- ou un -SO₂-, R⁹ signifie un hydrogène ou un alkaralkyle en C₈-C₁₆, un aralkyle en C₇-C₁₆, un alkycycloalkylalkyle en C₇-C₁₈, un alkylcycloalkyle en C₆-C₁₈, un cycloalkylalkyle en C₆-C₁₈, un cycloalkyle en C₅-C₈, un alcényle en C₂-C₅ ou un alkyle en C₁-C₁₂ non substitué ou substitué par les alcoxy en C₁-C₁₂ ou tétrahydrofuryle, R¹⁰ a une des significations données à R⁹ ou signifie un aryle en C₆-C₁₀ ; un halogénoaryle en C₆-C₁₀, un alcaryle en C₇-C₈ ou un halogénoalkyle en C₁-C₁₂, ou dans le cas où Y signifie un -CO- ou un -SO₂-, R¹⁰ signifie aussi -NR¹³R¹⁴, dans lequel R¹³ et R¹⁴ signifient, indépendamment l'un de l'autre, un hydrogène, un alkyle en C₁-C₁₂, un phényle, un benzyle ou un cyclohexyle ou R¹³ et R¹⁴ signifient ensemble un alkylène en C₄-C₅ ou un 3-oxopentaméthylène, ou R⁹ et R¹⁰ signifient ensemble un alkylène en C₂-C₈, et Z signifie un alcane-diyle en C₁-C₈ non substitué.

11. Titanocène selon la revendication 10, dans lequel R⁹ est un hydrogène, un alkyle en C₁-C₈ ou un aralkyle en C₇-C₉, R¹⁰ signifie un alkyle en C1-C18, un trifluorométhyle, un phényle ou un phényle substitué par les halogène ou alkyle en C₁-C₁₂ ou R⁹ et R¹⁰ signifient ensemble un alkylène en C₂-C₆, Y est un -CO- ou -SO₂- et Z signifie un alcane-diyle en C₁-C₄ non substitué.

12. Titanocène selon la revendication 1, caractérisé en ce que R² et R³ sont substitués par un groupe de formule IIb, dans laquelles R¹⁰ et R¹¹ signifient ensemble un alcane-diyle en C₂-C₈, un alcène-diyle en C₂-C₈, un arène-diyle en C₆-₁₄, un cyclohexane-diyle ou un bicycloalcane-diyle en C₇-C₁₂, Y est un -CO- et Z signifie un alcane-diyle en C₁-C₄ non substitué.

13. Composition polymérisable par irradiation, contenant (a) au moins un composé non volatil, monomère, oligomère ou polymère ayant au moins une double liaison insaturée éthylénique polymérisable et (b) au moins un titanocène de formule I selon la revendication 1 en tant que photoinitiateur et (c) éventuellement au moins un photoinitiateur supplémentaire, différent de (b).

14. Composition selon la revendication 13, contenant comme photoinitiateur (c) une benzophénone, un alkyléther de benzoïne, un cétal de benzile, un 4-aroyl-1,3-dioxolanne, une dialcoxyacétophénone, un α-hydroxy- ou α-aminoacétophénone ou une α-hydroxycycloalkylphénylcétone ou leurs mélanges en tant que photonitiateur supplémentaire.

15. Utilisation d'une composition selon la revendication 13, en vue de préparer des laques, des encres d'imprimerie, des planches d'impression ("Druckplatten"), des masses de dentisterie, des matériaux résiste ("Resist=materialen"), de même que des matériaux d'enregistrement d'images ("Bildaufzeichnungsmaterial").

16. Substrat enduit qui est enduit sur au moins une surface avec une composition selon la revendication 13.

17. Procédé de prépraration photographique de représentation en relief, caractérisé en ce que l'on irradie par des images un substrat enduit selon la revendication 16 et on élimine ensuite la partie non irradiée à l'aide d'un solvant.

18. Utilisation d'un titanocène de formule I selon la revendication 1, seul ou en association avec d'autres initiateurs tels que des photoinitiateurs en vue de la polymérisation de composés non volatils monomères, oligomères ou polymères ayant au moins une double liaison insaturée éthylénique polymérisable.

19. Mélange de photoinitiateurs, contenant un photoinitiateur du type des benzophénone, alkyléther de benzoïne, cétal de benzile, 4-aroyl-1,3-dioxolane, dialcoxyacétophénone, α-hydroxyacétophénone, α-hydroxycycloalkylphénylcétone, α-aminoacétophénone ou de leurs mélanges et d'un titanocène de formule I selon la revendication 1 selon un rapport pondéral compris entre 1:1 et 30:1.
